(19) Europäisches Patentamt
European Patent Office
Office européen des brevets

(11) **EP 4 738 735 A1**

(12) **EUROPEAN PATENT APPLICATION**
published in accordance with Art. 153(4) EPC

(43) Date of publication:
**06.05.2026 Bulletin 2026/19**

(21) Application number: **23950111.7**

(22) Date of filing: **30.08.2023**

(51) International Patent Classification (IPC):
**H04L 1/00** (2006.01)   **H04W 28/06** (2009.01)

(52) Cooperative Patent Classification (CPC):
**H04L 1/00; H04W 28/06**

(86) International application number:
**PCT/CN2023/115696**

(87) International publication number:
**WO 2025/043520 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
• LI, Jiahui
  Shenzhen, Guangdong 518129 (CN)
• MA, Mengyao
  Shenzhen, Guangdong 518129 (CN)
• LI, Yanchun
  Shenzhen, Guangdong 518129 (CN)

(74) Representative: **Maiwald GmbH
Elisenhof
Elisenstraße 3
80335 München (DE)**

(54) **DATA COMPRESSION METHOD AND APPARATUS, AND READABLE STORAGE MEDIUM**

(57)   This application may be applied to the field of communication technologies, and provides a data compression method, an apparatus, and a readable storage medium, to reduce a calculation amount during compression on input data. The method includes: obtaining a compressed bitstream based on a first mapping relationship, where the first mapping relationship corresponds to a bit width and a first parameter, the first mapping relationship includes a plurality of value ranges of a first element and a plurality of bit values of a data bitstream that correspond to each other, the first element is determined based on the input data, the data bitstream is a binary bitstream corresponding to a value range of the first element, a value of the bit width is related to a quantity of bits of a bit value of the data bitstream, and the first parameter is used to determine the value range of the first element.

FIG. 3

## Description

### TECHNICAL FIELD

This application relates to the field of communication technologies, and in particular, to a data compression method, an apparatus, and a readable storage medium.

### BACKGROUND

In an antenna and remote radio scenario, an antenna, a radio frequency unit, and the like of a base station are deployed at a remote end, and a baseband and a central compute node are deployed at a local end. A problem of data fronthaul between the remote end and the local end is considered. During uplink transmission, obtained sampling data needs to be transferred to the central compute node through an optical fiber or an Ethernet for subsequent operations such as baseband processing and data fusion. During downlink transmission, data sent from the central compute node needs to be obtained and processed by the radio frequency unit and then transmitted through the antenna. However, as a quantity of antennas and a quantity of distributed units increase, an amount of data requiring fronthaul surges sharply. To reduce a bandwidth requirement of a fronthaul link and system costs, fronthaul data needs to be compressed.

However, a current solution for compressing the fronthaul data needs to perform a large amount of calculation at a transmit end and a receive end, requires a large quantity of calculation resources, and is highly complex.

### SUMMARY

Embodiments of this application provide a data compression method, an apparatus, and a readable storage medium, to lower complexity of compressing data.

To achieve the foregoing objective, this application uses the following technical solutions.

According to a first aspect, a data compression method is provided. The method may be performed by a first unit, or may be performed by a module (for example, a processor, a chip, or a chip system) used in the first unit. Descriptions are provided below by using an example in which the first unit performs the method. The method includes: The first unit obtains input data to be compressed. The first unit obtains a compressed bitstream based on a first mapping relationship, where the first mapping relationship corresponds to a bit width and a first parameter, the first mapping relationship includes a plurality of value ranges of a first element and a plurality of bit values of a data bitstream that correspond to each other, the first element is determined based on the input data, the data bitstream is a binary bitstream corresponding to a value range of the first element, a value of the bit width is related to a quantity of bits of a bit value of the data bitstream, and the first parameter is used to determine the value range of the first element.

Based on the data compression method provided in embodiments of this application, the first unit can directly determine, based on the first mapping relationship, a bit value, of a data bitstream, corresponding to a value of a first element, so that a calculation amount required for some operations (for example, quantization) in a process of compressing the input data can be omitted, and the compressed bitstream can be obtained, thereby lowering complexity.

With reference to the first aspect, in a possible design, that the first element is determined based on the input data includes: The first element is the input data; or the first element is a real part and an imaginary part of the input data; or the first element is an element in an absolute value of the input data; or the first element is an element in a vector obtained after the input data is normalized.

Based on this solution, the first unit can perform specific processing on the input data to obtain the first element, and can determine a corresponding data bitstream based on a value of the first element and the first mapping relationship.

With reference to the first aspect, in a possible design, the first mapping relationship is determined from a second mapping relationship based on the bit width and/or the first parameter, and the second mapping relationship includes boundaries of all the value ranges of the first element in the first mapping relationship.

Based on this solution, the first mapping relationship may be included in the second mapping relationship, so that storage resources can be saved.

With reference to the first aspect, in a possible design, the first mapping relationship further includes the plurality of bit values of the data bitstream and a plurality of first restored values that correspond to each other, and the first restored value is a result obtained by dequantizing the data bitstream.

Based on this solution, the first mapping relationship may be further used to dequantize the data bitstream.

With reference to the first aspect, in a possible design, that the first unit obtains the compressed bitstream based on the first mapping relationship includes: The first unit blocks the input data to obtain a blocked result. The first unit determines, based on the first mapping relationship, a data bitstream corresponding to the blocked result. Then, the first unit performs packet assembly on the data bitstream and a frame header to obtain the compressed bitstream, where the frame header includes information indicating the first parameter.

With reference to the first aspect, in a possible design, after obtaining the blocked result, the method further includes: The first unit normalizes the blocked result based on a normalization coefficient to obtain a normalized result. That the first unit determines, based on the first mapping relationship, the data bitstream corresponding to the blocked result includes: The first unit determines, based on the first mapping relationship, a data bitstream corresponding to the normalized result.

Based on this solution, the first unit may further normalize the blocked result to obtain the normalized result with a value within [0, 1] or [-1, 1], and then determine the data bitstream corresponding to the normalized result.

With reference to the first aspect, in a possible design, the frame header further includes information indicating the normalization coefficient, and the information indicating the normalization coefficient includes a uniformly quantized value or a non-uniformly quantized value of the normalization coefficient.

Based on this solution, the normalization coefficient may be indicated by indicating a quantized value of the normalization coefficient. Compared with directly indicating the normalization coefficient, indicating the quantized value of the normalization coefficient requires lower overheads.

With reference to the first aspect, in a possible design, the information indicating the first parameter includes a quantized value of the first parameter.

Based on this solution, the normalization coefficient may be indicated by indicating the quantized value of the first parameter. Compared with directly indicating the first parameter, indicating the quantized value of the first parameter requires lower costs.

With reference to the first aspect, in a possible design, the first parameter is determined based on an optimization indicator, and the optimization indicator includes at least one of a normalized mean square error NMSE, a generalized cosine similarity GCS, a transmission throughput, and a bit error rate that correspond to a restored value obtained by dequantizing the data bitstream.

Based on this solution, a value of the first parameter that can make compressed data more reliable and have a smaller error may be determined based on the optimization indicator, so that better compression performance can be provided.

With reference to the first aspect, in a possible design, the method further includes: The first unit determines compression parameter information based on a first transmission configuration, where the first transmission configuration is related to a signal bandwidth and/or a quantity of signal transmission streams, and the compression parameter information includes at least one of the following: a block size, a target compression ratio, the bit width, a downsampling ratio, a transform mode, the first parameter, a boundary of the value range of the first element, or a boundary of a value range of the normalization coefficient.

Based on this solution, the first unit can determine the compression parameter information based on the transmission configuration, so that the compressed bitstream obtained based on the compression parameter information can ensure end-to-end performance. In addition, the first unit can dynamically update the compression parameter information based on a current transmission configuration.

With reference to the first aspect, in a possible design, the method further includes: The first unit obtains a third mapping relationship, where the third mapping relationship includes a second transmission configuration and compression parameter information that correspond to each other, the second transmission configuration is related to a modulation and coding scheme of a signal, and the compression parameter information includes at least one of the following: a block size, a target compression ratio, the bit width, a downsampling ratio, a transform mode, the first parameter, a boundary of the value range of the first element, or a boundary of a value range of the normalization coefficient.

Based on this solution, the first unit can determine the corresponding compression parameter information based on the second transmission configuration in the third mapping relationship, so that the compressed bitstream obtained based on the compression parameter information can ensure end-to-end performance. In addition, the first unit can dynamically update the compression parameter information based on a current transmission configuration.

With reference to the first aspect, in a possible design, the method further includes: The first unit receives compression parameter information, where the compression parameter information includes at least one of the following: a block size, a target compression ratio, the bit width, a downsampling ratio, a transform mode, the first parameter, a boundary of the value range of the first element, or a boundary of a value range of the normalization coefficient.

Based on this solution, the first unit can receive the compression parameter information configured by another device.

With reference to the first aspect, in a possible design, the method further includes: The first unit sends the compression parameter information, where the compression parameter information includes the at least one of the following: the block size, the target compression ratio, the bit width, the downsampling ratio, the transform mode, the first parameter, the boundary of the value range of the first element, or the boundary of the value range of the normalization coefficient.

Based on this solution, the first unit can send the compression parameter information to another device, so that the another device can align the compression parameter information with the first unit.

According to a second aspect, a data compression method is provided. The method may be performed by a second unit, or may be performed by a module (for example, a processor, a chip, or a chip system) used in the second unit. Descriptions are provided below by using an example in which the second unit performs the method. The method includes: The second unit receives a compressed bitstream, where the compressed bitstream includes a frame header and a data bitstream. The second unit obtains, based on a fourth mapping relationship, reconstructed data corresponding to the compressed bitstream, where the fourth mapping relationship corresponds to a bit width and a first parameter, the fourth mapping relationship includes a plurality of bit values of a data bitstream and a plurality of first restored values that correspond to each other, and the first restored value is a result obtained by dequantizing the data bitstream.

Based on the data compression method provided in embodiments of this application, the second unit can directly determine, based on the fourth mapping relationship, a first restored value corresponding to a bit value of a data bitstream, so that a calculation amount required for some operations (for example, dequantization) in a process of restoring the compressed data bitstream can be omitted, and restored data can be obtained, thereby lowering complexity.

With reference to the second aspect, in a possible design, the fourth mapping relationship further includes a plurality of value ranges of a first element and the plurality of bit values of the data bitstream that correspond to each other, the first element is related to input data, and the compressed bitstream is determined based on the input data.

Based on this solution, the fourth mapping relationship may be further used to compress data to obtain a compressed bitstream.

With reference to the second aspect, in a possible design, the fourth mapping relationship is determined from a second mapping relationship based on the bit width and/or the first parameter, and the second mapping relationship includes boundaries of all the value ranges of the first element in the fourth mapping relationship.

Based on this solution, the fourth mapping relationship may be included in the second mapping relationship, so that storage resources can be saved.

With reference to the second aspect, in a possible design, the frame header further includes information indicating a normalization coefficient. That the second unit obtains, based on the fourth mapping relationship, the reconstructed data corresponding to the compressed bitstream includes: The second unit obtains, based on the fourth mapping relationship, a restored value corresponding to a data bitstream in the compressed bitstream. The second unit de-normalizes the restored value based on the normalization coefficient to obtain the reconstructed data.

Based on this solution, the second unit can de-normalize the restored value based on the normalization coefficient indicated by the frame header, to obtain the reconstructed data.

With reference to the second aspect, in a possible design, the information indicating the normalization coefficient includes a uniformly quantized value or a non-uniformly quantized value of the normalization coefficient.

Based on this solution, the normalization coefficient may be indicated by indicating a quantized value of the normalization coefficient. Compared with directly indicating the normalization coefficient, indicating the quantized value of the normalization coefficient requires lower overheads.

With reference to the second aspect, in a possible design, the frame header includes information indicating the first parameter, and the information indicating the first parameter includes a quantized value of the first parameter.

Based on this solution, the normalization coefficient may be indicated by indicating the quantized value of the first parameter. Compared with directly indicating the first parameter, indicating the quantized value of the first parameter requires lower costs.

With reference to the second aspect, in a possible design, the first parameter is determined based on an optimization indicator, and the optimization indicator includes at least one of a normalized mean square error NMSE, a generalized cosine similarity GCS, a transmission throughput, and a bit error rate that correspond to the restored value obtained by dequantizing the data bitstream.

Based on this solution, a value of the first parameter that can make compressed data more reliable and have a smaller error may be determined based on the optimization indicator, so that better compression performance can be provided.

With reference to the second aspect, in a possible design, the method further includes: The second unit determines compression parameter information based on a first transmission configuration, where the first transmission configuration is related to a signal bandwidth and/or a quantity of signal transmission streams, and the compression parameter information includes at least one of the following: a block size, a target compression ratio, the bit width, a downsampling ratio, a transform mode, the first parameter, a boundary of a value range of the first element, or a boundary of a value range of the normalization coefficient.

Based on this solution, the second unit can determine the compression parameter information based on the transmission configuration, so that the compressed bitstream obtained based on the compression parameter information can ensure end-to-end performance. In addition, the second unit can dynamically update the compression parameter information based on a current transmission configuration.

With reference to the second aspect, in a possible design, the method further includes: The second unit obtains a third mapping relationship, where the third mapping relationship includes a mapping relationship between a second transmission configuration and compression parameter information, the second transmission configuration is related to a modulation and coding scheme of a signal, and the compression parameter information includes at least one of the following: a block size, a target compression ratio, the bit width, a downsampling ratio, a transform mode, the first parameter, a boundary of a value range of the first element, or a boundary of a value range of the normalization coefficient.

Based on this solution, the second unit can determine the corresponding compression parameter information based on the second transmission configuration in the third mapping relationship, so that the compressed bitstream obtained based on the compression parameter information can ensure end-to-end performance. In addition, the second unit can dynamically update the compression parameter information based on a current transmission configuration.

With reference to the second aspect, in a possible design, the method further includes: The second unit receives compression parameter information, where the compression parameter information includes at least one of the following: a block size, a target compression ratio, the bit width, a downsampling ratio, a transform mode, the first parameter, a boundary of a value range of the first element, or a boundary of a value range of the normalization coefficient.

Based on this solution, the second unit can receive the compression parameter information configured by another device.

With reference to the second aspect, in a possible design, the method further includes: The second unit sends the compression parameter information, where the compression parameter information includes the at least one of the following: the block size, the target compression ratio, the bit width, the downsampling ratio, the transform mode, the first parameter, the boundary of the value range of the first element, or the boundary of the value range of the normalization coefficient.

Based on this solution, the second unit can send the compression parameter information to another device, so that the another device can align the compression parameter information with the second unit.

According to a third aspect, a communication apparatus is provided, to implement various methods. The communication apparatus includes corresponding modules, units, or means (means) for implementing the methods. The modules, units, or means may be implemented by hardware, software, or hardware executing corresponding software. The hardware or the software includes one or more modules or units corresponding to functions.

In some possible designs, the communication apparatus may include a processing module and a transceiver module. The processing module may be configured to implement a processing function in any one of the foregoing aspects and the possible implementations of the foregoing aspects. The transceiver module may include a receiving module and a sending module that are respectively configured to implement a receiving function and a sending function in any one of the foregoing aspects and the possible implementations of the foregoing aspects.

In some possible designs, the transceiver module may include a transceiver circuit, a transceiver machine, a transceiver, or a communication interface.

According to a fourth aspect, a communication apparatus is provided, and includes a processor and a memory. The memory is configured to store computer instructions, and when the processor executes the instructions, the communication apparatus is enabled to perform the method according to any one of the foregoing aspects.

According to a fifth aspect, a communication apparatus is provided, and includes a processor and a communication interface. The communication interface is configured to communicate with a module outside the communication apparatus, and the processor is configured to execute a computer program or instructions, to enable the communication apparatus to perform the method according to any one of the foregoing aspects.

According to a sixth aspect, a communication apparatus is provided, and includes at least one processor. The processor is configured to execute a computer program or instructions stored in a memory, to enable the communication apparatus to perform the method according to any one of the foregoing aspects. The memory may be coupled to the processor, or may be independent of the processor.

According to a seventh aspect, a computer-readable storage medium is provided. The computer-readable storage medium stores a computer program or instructions. When the computer program or the instructions are run on a communication apparatus, the communication apparatus is enabled to perform the method according to any one of the foregoing aspects.

According to an eighth aspect, a computer program product including instructions is provided. When the computer program product is run on a communication apparatus, the communication apparatus is enabled to perform the method according to any one of the foregoing aspects.

According to a ninth aspect, a communication apparatus (for example, the communication apparatus may be a chip or a chip system) is provided. The communication apparatus includes a processor, configured to implement the function according to any one of the foregoing aspects.

In some possible designs, the communication apparatus includes a memory, and the memory is configured to store necessary program instructions and data.

In some possible designs, when the apparatus is the chip system, the apparatus may include a chip, or may include the chip and another discrete component.

The communication apparatus provided in any one of the third aspect to the ninth aspect may be the first unit in the first aspect, or an apparatus included in the first unit, for example, a chip or a chip system. Alternatively, the communication apparatus may be the second unit in the second aspect, or an apparatus included in the second unit, for example, a chip or a chip system.

It may be understood that when the communication apparatus in any one of the third aspect to the ninth aspect is the chip, a sending action/function of the communication apparatus may be understood as outputting information, and a receiving action/function of the communication apparatus may be understood as inputting information.

For technical effect brought by any design of the third aspect to the ninth aspect, refer to the technical effect brought by different designs of the first aspect and the second aspect. Details are not described herein again.

**BRIEF DESCRIPTION OF DRAWINGS**

FIG. 1 is a schematic flowchart of a data compression solution;
FIG. 2 is a diagram of a structure of a communication system according to an embodiment of this application;
FIG. 3 is a schematic flowchart of a data compression method according to an embodiment of this application;
FIG. 4 is a diagram in which first mapping relationships are nested in a second mapping relationship according to an embodiment of this application;
FIG. 5 is a schematic flowchart of another data compression method according to an embodiment of this application;
FIG. 6 is a diagram of a structure of a compressed bitstream according to an embodiment of this application;
FIG. 7 is a diagram of a result of another compressed bitstream according to an embodiment of this application;
FIG. 8 is a schematic flowchart of another data compression method according to an embodiment of this application;
FIG. 9 is a diagram of compression parameter information according to an embodiment of this application;
FIG. 10 is a diagram of configuring compression parameter information according to an embodiment of this application;
FIG. 11 is a diagram of a structure of a communication apparatus according to an embodiment of this application; and
FIG. 12 is a diagram of a structure of another communication apparatus according to an embodiment of this application.

**DESCRIPTION OF EMBODIMENTS**

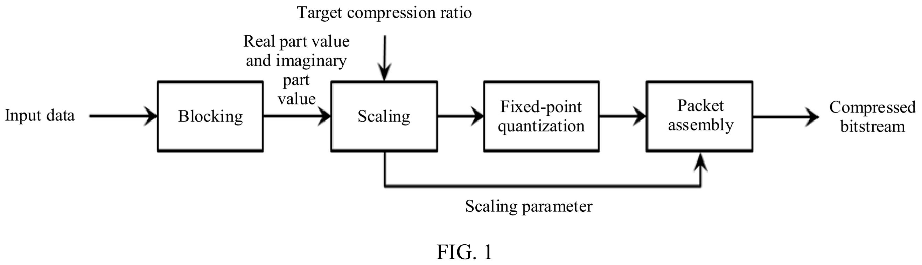

FIG. 1 is a flowchart of a block scaling-based data compression solution. As shown in FIG. 1, the data compression solution mainly includes the following steps.

1: Block input data (if the input data is complex data, split the input data into a real part and an imaginary part and then concatenate the real part and the imaginary part), and find a maximum amplitude of the blocked data.
2: Determine a bit width based on a given target compression ratio, determine a scaling parameter based on the bit width and the maximum amplitude of the blocked data, scale the blocked data based on a scaling parameter to obtain scaled data, and place the scaling parameter at a frame header, where a value of the bit width is equivalent to a quantity of bits required for representing the scaled data, for example, it is assumed that the bit width is 4, the scaled data is represented by four bits based on the scaling parameter determined based on the bit width.
3: Perform fixed-point quantization on the scaled data to obtain a data bitstream.
4: Perform packet assembly on the frame header and the data bitstream to obtain a compressed bitstream.

However, in a current data compression solution, a data transmit end needs to calculate a scaling parameter, and then quantize data based on the scaling parameter. This process requires a large amount of calculation. Correspondingly, a data receive end also needs to perform a large amount of calculation to dequantize a compressed bitstream, to restore the original data. It can be learned that a current data compression solution is highly complex, and requires a large quantity of calculation resources. If the solution is applied to a data fronthaul scenario, two ends for data transmission may be burdened, and a data transmission delay may be increased. Based on this problem, embodiments of this application provide a low-complexity and easy-to-implement data compression method, to reduce calculation resources required in a data compression process.

The following describes technical solutions in embodiments of this application with reference to accompanying drawings in embodiments of this application. In descriptions of this application, unless otherwise specified, "/" represents an "or" relationship between associated objects. For example, A/B may represent A or B. In this application, "and/or" describes only an association relationship between associated objects and represents that three relationships may exist. For example, A and/or B may represent the following three cases: Only A exists, both A and B exist, and only B exists, where A or B may be singular or plural. In addition, in the descriptions of this application, "a plurality of" means two or more than two unless otherwise specified. "At least one of the following items (pieces)" or a similar expression thereof indicates any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural. In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, terms such as "example" or "for example" are used to give an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

In embodiments of this application, "indication" may include a direct indication and an indirect indication, or may include an explicit indication and an implicit indication. Information indicated by a piece of information is referred to as to-be-indicated information. In a specific implementation process, the to-be-indicated information may be indicated in a plurality of manners, for example, but not limited to being directly indicated, for example, by using the to-be-indicated information or an index of the to-be-indicated information. Alternatively, the to-be-indicated information may be indirectly indicated by indicating other information, and there is an association relationship between the other information and the to-be-indicated information. Alternatively, only a part of the to-be-indicated information may be indicated, and the other part of the to-be-indicated information is known or pre-agreed on. For example, specific information may alternatively be indicated by using an arrangement sequence of a plurality of pieces of information that is pre-agreed on (for example, specified in a protocol), to reduce indication overheads to some extent. In addition, common parts of all pieces of information may be further identified and then indicated together, to reduce indication overheads caused by separately indicating same information.

Furthermore, specific indication manners may alternatively be various existing indication manners, for example, but not limited to, the foregoing indication manners and various combinations thereof. For details of the various indication manners, refer to the conventional technology. The details are not described in this specification. It can be learned from the foregoing descriptions that, for example, when a plurality of pieces of information of a same type need to be indicated, different information may be indicated in different manners. In a specific implementation process, a required indication manner may be selected based on a specific requirement. The selected indication manner is not limited in embodiments of this application. In this way, the indication manner in embodiments of this application should be understood as covering various methods that can enable a to-be-indicated party to learn of to-be-indicated information.

In embodiments of this application, "predefined, "predefinition, "preconfigured", or "preconfiguration" may be implemented by pre-storing corresponding code or a corresponding table in a device, or may be implemented in another manner for indicating related information, for example, may be burnt into the device before delivery of the device. A specific implementation is not limited in embodiments of this application. "Storage" may be storage in one or more memories. The one or more memories may be separately disposed, or may be integrated into an encoder or a decoder, a processor, or a communication apparatus. Alternatively, some of the one or more memories may be separately disposed, and some of the one or more memories are integrated into a decoder, a processor, or a communication apparatus. A type of the memory may be a storage medium in any form. This is not limited in embodiments of this application.

In embodiments of this application, descriptions such as "when ...", "in a case of ...", and "if" all mean that a device performs corresponding processing in a specific objective situation, and are not intended to limit time. The descriptions do not mean that the device is required to have a determining action during implementation, and do not mean any other limitation.

It should be noted that a network architecture and a service scenario described in embodiments of this application are intended to describe the technical solutions in embodiments of this application more clearly, and do not constitute a limitation on the technical solutions provided in embodiments of this application. A person of ordinary skill in the art may know that: With the evolution of the network architecture and the emergence of new service scenarios, the technical solutions provided in embodiments of this application are also applicable to similar technical problems.

The data compression method provided in embodiments of this application may be applied to a cellular system related to the 3rd Generation Partnership Project (3rd generation partnership project, 3GPP), for example, a long term evolution (long term evolution, LTE) system, a 5th generation mobile communication technology (5th generation mobile communication technology, 5G) system, or a future-oriented evolved system (for example, a 6G mobile communication system). Alternatively, the data compression method may be applied to an open radio access network (open radio access network, O-RAN or ORAN), a cloud radio access network (cloud radio access network, CRAN), or a wireless fidelity (wireless fidelity, Wi-Fi) system. The data compression method provided in embodiments of this application may be further applied to a communication system in which two or more of the foregoing systems are integrated. In addition, terms "system" and "network" may be interchangeable with each other.

The data compression method provided in embodiments of this application may be applied to a scenario in which a plurality of radio access network (radio access network, RAN) nodes collaborate with each other to assist a terminal in implementing radio access. In this scenario, different RAN nodes separately implement some functions of a base station. For example, the RAN node may be a central unit (central unit, CU), a distributed unit (distributed unit, DU), a CU-control plane (control plane, CP), a CU-user plane (user plane, UP), or a radio unit (radio unit, RU). The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may alternatively have different names, but a person skilled in the art may understand meanings thereof. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination of a software module and a hardware module.

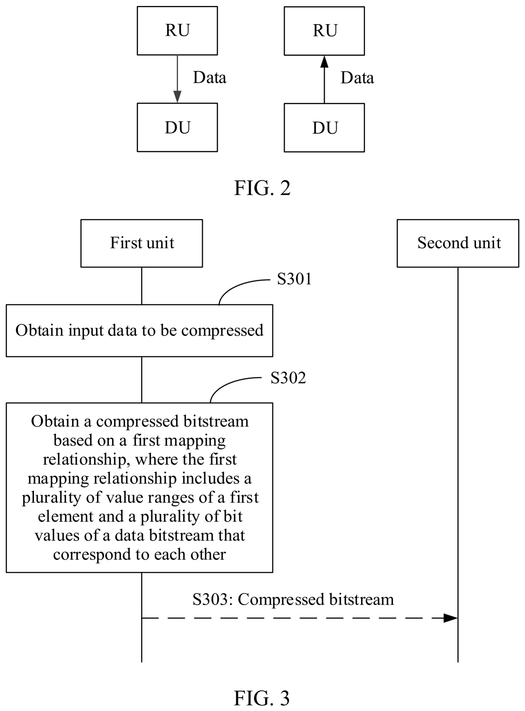

In the data compression method provided in embodiments of this application, two ends for data transmission may be a DU and an RU. Data transmission between the DU and the RU may be referred to as data fronthaul. For example, as shown in FIG. 2, the DU may be used as a data transmit end to send data to the RU, and correspondingly, the RU may be used as a data receive end to receive the data. Alternatively, the RU may be used as a data transmit end to send data to the DU, and correspondingly, the DU may be used as a data receive end to receive the data.

In the following, a data transmit end is referred to as a first unit, and a data receive end is referred to as a second unit. In the data compression method provided in embodiments of this application, the first unit obtains input data to be compressed, and obtains a compressed bitstream based on a first mapping relationship. The first mapping relationship corresponds to a bit width and a first parameter, the first mapping relationship includes a plurality of value ranges of a first element and a plurality of bit values of a data bitstream that correspond to each other, the first element is determined based on the input data, the data bitstream is a binary bitstream corresponding to a value range of the first element, a value of the bit width is related to a quantity of bits of a bit value of the data bitstream, and the first parameter is used to determine the value range of the first element. The transmit end sends the compressed bitstream to the receive end, where the compressed bitstream includes a frame header and a data bitstream, and the frame header includes information indicating the first parameter. After receiving the compressed bitstream, the second unit obtains reconstructed data corresponding to the compressed bitstream based on a fourth mapping relationship. The fourth mapping relationship corresponds to the bit width and the first parameter, and the fourth mapping relationship includes the plurality of bit values of the data bitstream and a plurality of first restored values that correspond to each other. The first restored value is a result obtained by dequantizing the data bitstream. Specific implementations and technical effect of the solution are described in detail in subsequent method embodiments. Details are not described herein.

The following describes in detail the data compression method provided in embodiments of this application with reference to FIG. 1 and FIG. 2.

It should be noted that names of messages between network elements, names of parameters in the messages, or the like in the following embodiments of this application are merely examples, and there may be other names in a specific implementation. This is not specifically limited in embodiments of this application.

It should be noted that in embodiments of this application, "sending data/information to a second unit" or related indications in the accompanying drawings may be understood as that a destination end of the data/information is the second unit, and may include directly or indirectly sending the data/information to the second unit. "Sending data/information by a first unit", "receiving, from a first unit, data/information", "receiving data/information from a first unit", or related indications in the accompanying drawings may be understood as that a source end of the data/information is the first unit, and may include directly or indirectly receiving the data/information from the first unit. Necessary processing, for example, format change, may be performed on the data/information between the data/information sending source end and the data/information sending destination end, but the destination end may understand valid data/information from the source end. A similar expression in this application may be understood similarly. Details are not described herein again.

FIG. 3 shows a data compression method according to an embodiment of this application. The data compression method includes steps S301 and S302.

S301: A first unit obtains input data to be compressed.

The input data needs to be sent to a second unit, and the input data needs to be compressed before being sent to the second unit.

In embodiments of this application, the input data may also be referred to as original data, and the input data and the original data may be replaced with each other.

S302: The first unit obtains a compressed bitstream based on a first mapping relationship, where the first mapping relationship corresponds to a bit width and a first parameter, the first mapping relationship includes a plurality of value ranges of a first element and a plurality of bit values of a data bitstream that correspond to each other, the first element is determined based on the input data, the data bitstream is a binary bitstream corresponding to a value range of the first element, a value of the bit width is related to a quantity of bits of a bit value of the data bitstream, and the first parameter is used to determine the value range of the first element.

In S302, the first unit may first perform specific processing on the input data, use an obtained related element as the first element, and determine, based on the first mapping relationship, a bit value, of the data bitstream, corresponding to a value of the first element, and use the bit value of the corresponding data bitstream as a bit value of the data bitstream obtained after the input data is compressed.

It may be understood that because the first unit can directly determine, based on the first mapping relationship, the bit value, of the data bitstream, corresponding to the value of the first element, a calculation amount required for some operations (for example, quantization) in a process of compressing the input data can be omitted, and the data bitstream can be obtained, thereby lowering complexity.

The following describes the first mapping relationship in detail.

In embodiments of this application, the first mapping relationship corresponds to the bit width and the first parameter. The following separately describes the bit width and the first parameter.

For the bit width, the bit width may be a value. The bit width is related to the quantity of bits of the bit value, of the data bitstream, included in the first mapping relationship. Specifically, in the first mapping relationship, the bit value, of the data bitstream, corresponding to the value range of the first element may be obtained by quantizing the first element based on the bit width. Therefore, a larger bit width indicates a larger quantity of bits of the bit value of the data bitstream, and a smaller bit width indicates a smaller quantity of bits of the bit value of the data bitstream. In other words, if the input data is compressed based on the first mapping relationship to obtain the compressed data bitstream, the bit width may be used to determine a quantity of bits of a bit value of the compressed data bitstream.

For example, the bit width may be denoted as b, and the data bitstream may be denoted as $B$. Because one bit in the bit width is a sign bit of a positive or negative sign, the quantity of bits of the bit value of the data bitstream $B$ may be equal to $b$-1.

For the first parameter, the first parameter may be a parameter in a function (for example, a parameter in a nonlinear function), or may be a value. The first parameter is used to determine the value range of the first element, or the first parameter is related to the value range of the first element.

For determining of the value range of the first element, optionally, the first parameter may be used to determine a boundary of the value range of the first element. The boundary of the value range of the first element may be an upper limit value or a lower limit value of the value range of the first element.

In a possible implementation, the boundary of the value range of the first element may be obtained through calculation based on a value of the first parameter and a preset formula/algorithm.

For example, the first parameter may be denoted as $P$, and the boundary of the value range of the first element may be denoted as $Q_b(P)$ (where $b$ is the bit width). It is assumed that a quantity of boundaries $Q_3(P)=2^{b-1}-1$. If $b=4$, there are seven boundaries $Q_b(P)$ in total. Each $Q_b(P)$ may be obtained through calculation based on a value of $b$, a value of $P$, and a preset formula/algorithm. If the first parameter is the parameter in the nonlinear function, the preset formula/algorithm for determining $Q_b(P)$ may be the nonlinear function to which the first parameter belongs.

In another possible implementation, the first parameter may be identification information of the boundary of the value range of the first element, and the first unit may determine, based on the first parameter, the corresponding boundary of the value range of the first element. In this implementation, a value of the first parameter may be a number of the boundary of the value range of the first element.

For example, it is assumed that boundaries of two value ranges of the first element are preset in the first unit, and each value range has boundaries of a plurality of value ranges of the first element. Numbers (namely, values of the corresponding first parameter) of the boundaries of the two value ranges of the first element are 1 and 2, respectively.

In a possible implementation, the bit value, of the data bitstream, corresponding to the value range of the first element in the first mapping relationship may be obtained by transforming the first element based on the first parameter corresponding to the first mapping relationship, and then uniformly quantizing a transformed result based on the bit width. In other words, if the input data is compressed based on the first parameter and the bit width, the first parameter may be used to transform the first element to obtain the transformed result, and the transformed result may be further uniformly quantized based on the bit width to obtain the data bitstream. It may be understood that if the first parameter is the parameter in the nonlinear function, the first element may be transformed based on the first parameter, and then the transformed result may be quantized based on the bit width. This can implement non-uniform quantization on the first element.

For example, the first parameter may be a parameter related to cumulative distribution function (cumulative distribution function, CDF) transform or Mu rate transform.

For example, it is assumed that a vector to which the first element belongs is denoted as $A'$. If CDF transform is performed on *A'*, and a transformed result is denoted as *A"*, *A"* may satisfy the following relationship:

$$A''[k] = F_{A'}(A'[k]) \qquad\qquad \text{Formula (1)}$$

Herein, $F_{A'}(\cdot)$ indicates a CDF of an element (namely, the first element) in *A'*, and *k* indicates a $k^{th}$ first element in *A'*.

Further, for example, a random variable *x* satisfies a Gaussian distribution. $F_{A'}(x)$ may satisfy the following relationship:

$$F_{A'}(x) = \frac{1}{\sigma\sqrt{2\pi}} \int_{-\infty}^{x} exp\left(-\frac{(t-\mu)^2}{2\sigma^2}\right) dt \qquad\qquad \text{Formula (2)}$$

Herein, $\mu$ and $\sigma^2$ are a mean value and a variance of the Gaussian distribution to which *x* conforms, respectively. The first parameter $P=\{\mu, \sigma^2\}$. An output result *A"* (namely, the transformed result *A"*) conforms to a uniform distribution of [0, 1].

For another example, it is assumed that a vector to which the first element belongs is denoted as *A'*. If Mu rate transform is performed on *A'*, and a transformed result is denoted as *A"*, *A"* may satisfy the following relationship:

$$A''[k]=\ln(1+\mu A'[k])/\ln(1+\mu) \qquad\qquad \text{Formula (3)}$$

Herein, $\mu$ indicates a transform parameter in Mu rate transform. In other words, the first parameter $P=\{\mu\}$. A value range of $\mu$ is $(0, +\infty)$, and a value range of an output result *A"* (namely, the transformed result *A"*) is [0, 1]. When a value of $\mu$ is close to 0, *A"* falls back to the original *A'*, that is, no transform is performed. When a value of $\mu$ is large, after *A'* is transformed, quantization precision of the first element with a small amplitude in *A'* is improved.

For example, it is assumed that the bit width corresponding to the first mapping relationship is 4, and the corresponding first parameter is a parameter *P* related to Mu rate transform, where $P=\mu=2$. The first mapping relationship may be shown in Table 1.

Table 1

| Value range of the first element | [0, 0.05] | (0.05, 0.1] | (0.1, 0.2] | (0.2, 0.35] | (0.35, 0.5] | (0.5, 0.7] | (0.7, 0.85] | (0.85, 1] |
|---|---|---|---|---|---|---|---|---|
| Bit value of the data bitstream | 000 | 001 | 010 | 011 | 100 | 101 | 110 | 111 |

It should be noted that a representation form of the first mapping relationship is not limited in embodiments of this application. The table form is merely an example of a possible representation form. The first mapping relationship may also be in another representation form, for example, may be a string of digital sequences. The data sequences include the value ranges of the first element and the bit values of the data bitstream that are arranged in a specific order.

Optionally, the first mapping relationship may further include the plurality of bit values of the data bitstream and a plurality of first restored values that correspond to each other. The first restored value is a result obtained by dequantizing the data bitstream. Details are described in another embodiment below. Details are not described herein.

The first unit may pre-obtain one or more first mapping relationships, and determine, from the one or more first mapping relationships, the first mapping relationship used to compress the data this time.

For obtaining of the first mapping relationship, optionally, the first mapping relationship may be preconfigured in the first unit. Alternatively, the first mapping relationship may be configured by using higher layer signaling, for example, may be configured by using medium access control (medium access control, MAC) signaling or radio resource control (radio resource control, RRC) signaling. Alternatively, the first mapping relationship may be configured by using physical layer signaling, for example, may be configured by using physical downlink control channel (physical downlink control channel, PDCCH) signaling. Alternatively, the first mapping relationship may be generated by the first unit. For example, the first unit may dynamically generate the first mapping relationship based on a current transmission configuration. A manner in which the first unit obtains the first mapping relationship is not limited in embodiments of this application.

If the first unit obtains one first mapping relationship, the first unit may determine the corresponding compressed bitstream based on the first mapping relationship and the input data.

If the first unit obtains a plurality of first mapping relationships, the first unit may first determine the value of the bit width and the value of the first parameter that are used to compress the input data this time, and then determine the corresponding first mapping relationship, where the first mapping relationship is the first mapping relationship used to compress the data this time. The first unit further determines the corresponding compressed bitstream based on the first mapping relationship.

For determining of the value of the bit width used to compress the input data this time, the value of the bit width may be preconfigured, or may be configured by using signaling (for example, higher layer signaling, physical layer signaling, or other signaling), or may be configured by a receive end (namely, the second unit) of the compressed bitstream, or may be determined by the first unit based on related information, or may be randomly determined by the first unit, or may be determined in another manner. This is not limited in embodiments of this application.

For example, the first unit may determine the bit width based on a target compression ratio. The target compression ratio is a ratio of a size of an expected compressed bitstream to a size of the input data. The target compression ratio and the bit width may satisfy the following relationship:

$$\max b \text{ s. t. } nN_0 * N_{\text{data}}/(L_{\text{header}} + nM_0 b) \geq D \qquad \text{Formula (4)}$$

Herein, b indicates a bit width (a bit width used to uniformly quantize the transformed result), s.t. indicates a constraint condition that needs to be satisfied, max X s.t. Y indicates maximizing X to satisfy a condition Y, n=1 and 2 respectively indicate a real-valued signal and a complex-valued signal (two channels I/Q), $N_{\text{data}}$ indicates a bit width of the input data, for example, may be determined by using an effective bit width of an analog to digital converter (analog to digital converter, ADC) or a digital to analog converter (digital analog converter, DAC), $L_{\text{header}}$ indicates a length of a frame header part in the compressed bitstream, and $N_0$ and $M_0$ respectively indicate an original length and a length obtained through preprocessing (for example, downsampling) of each code block after the input data is blocked (blocking and preprocessing are specifically described below, and are not described herein).

Optionally, the target compression ratio may be preconfigured, or may be configured by using signaling (for example, higher layer signaling, physical layer signaling, or other signaling), or may be configured by the receive end (namely, the second unit) of the compressed bitstream, or may be determined by the first unit based on related information, or may be randomly determined by the first unit, or may be determined in another manner. This is not limited in embodiments of this application.

For determining of the value of the first parameter required to compress the input data, the value may be preconfigured, or may be configured by using signaling (for example, higher layer signaling, physical layer signaling, or other signaling), or may be configured by the receive end (namely, the second unit) of the compressed bitstream; or the value may be determined based on an optimization indicator, or may be randomly determined by the first unit, or may be determined by the first unit based on related information, or may be determined in another manner. This is not limited in embodiments of this application.

The following describes in detail a manner of determining the value of the first parameter based on the optimization indicator.

The optimization indicator may be understood as an indicator that corresponds to a restored value obtained by dequantizing a data bitstream and that can represent (or be referred to as evaluate) reliability of the restored value. For example, the optimization indicator may include at least one of indicators such as a normalized mean square error (normalized mean square error, NMSE), a generalized cosine similarity (generalized cosine similarity, GCS), a transmission throughput rate, and a bit error rate that correspond to the restored value obtained by dequantizing the data bitstream.

The first unit may determine, based on optimization indicators respectively corresponding to different values of the first parameter, a value of the first parameter that has a good optimization indicator as the value of the first parameter used to compress the data this time. The different values of the first parameter may be preset, or may be determined from a preset value range, or may be determined in another manner. This is not limited in embodiments of this application.

Specifically, the first unit may determine the value of the bit width required to compress the input data this time, and then obtain a plurality of first mapping relationships that correspond to the bit width and the different values of the first parameter. The first unit may determine, based on the input data and bit values of data bitstreams included in the plurality of first mapping relationships, different data bitstreams corresponding to the different values of the first parameter. Further, the first unit may determine restored values obtained by dequantizing the different data bitstreams, and calculate optimization indicators corresponding to the restored values, to obtain optimization indicators corresponding to the different values of the first parameter.

Optionally, if the first mapping relationship further includes the plurality of bit values of the data bitstreams and the plurality of first restored values that correspond to each other, when determining the restored values obtained by dequantizing the different data bitstreams, the first unit may directly query the first mapping relationship and determine the first restored values as the restored values obtained by dequantizing the data bitstreams. Alternatively, the first unit may obtain, through calculation based on the bit width and the first parameter, the restored values obtained by dequantizing the different data bitstreams.

For example, if the optimization indicator is the normalized mean square error (indicating a normalized mean square error between the restored value and the input data) corresponding to the restored value obtained by dequantizing the data bitstream, the first unit may determine a value of the first parameter corresponding to a smallest normalized mean square error as the value of the first parameter used to compress the input data this time. For another example, if the optimization indicator is the generalized cosine similarity (indicating a generalized cosine similarity between the restored value and the input data) corresponding to the restored value obtained by dequantizing the data bitstream, the first unit may determine a value of the first parameter corresponding to a highest generalized cosine similarity as the value of the first parameter used to compress the input data this time.

Optionally, if the first unit may send the determined first parameter and/or bit width to the second unit, the second unit restores the compressed bitstream based on the first parameter and/or the bit width. In other words, the first unit and the second unit need to align the first parameter and/or the bit width used to compress the input data with the first parameter and/or the bit width used to restore the compressed bitstream.

Optionally, if the first unit obtains the plurality of first mapping relationships, the first mapping relationship used to compress the input data this time may be determined from a second mapping relationship based on the bit width and/or the first parameter, where the second mapping relationship includes boundaries of all the value ranges of the first element in the first mapping relationship. It may also be understood as that the first mapping relationship is nested in the second mapping relationship.

The boundary of the value range of the first element may be the upper limit value of the value range of the first element, or may be the lower limit value of the value range of the first element.

Optionally, different first mapping relationships nested in the second mapping relationship may correspond to a same first parameter and different bit widths. Alternatively, different first mapping relationships nested in the second mapping relationship may be determined in another manner. This is not limited in embodiments of this application.

It should be noted that a representation form of the second mapping relationship is not limited in embodiments of this application. The second mapping relationship may be in a table form or another form.

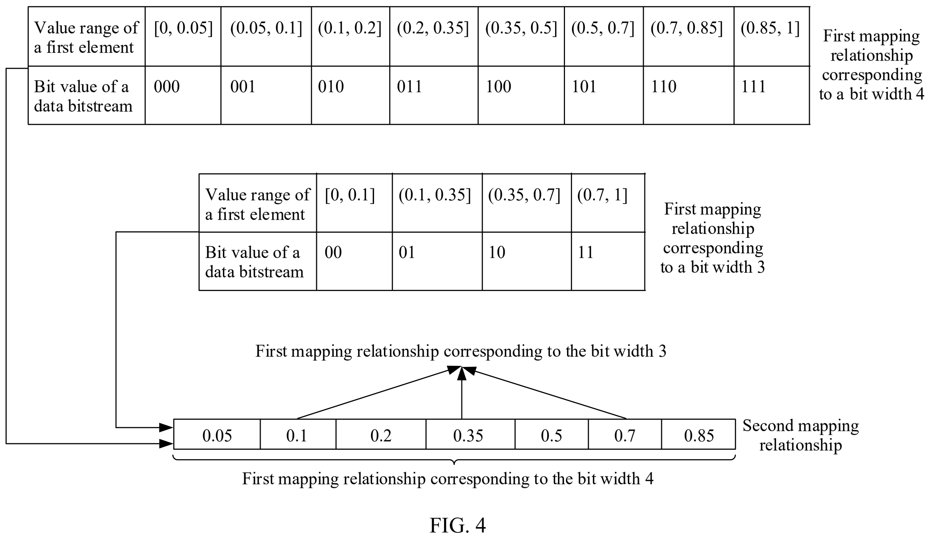

For example, FIG. 4 is a diagram in which two first mapping relationships are nested in a second mapping relationship. As shown in FIG. 4, bit widths corresponding to the two first mapping relationships are 3 and 4, respectively, and the two first mapping relationships correspond to a same first parameter. The second mapping relationship is in a table form, and includes upper limit values of all value ranges of a first element in the two first mapping relationships.

The first mapping relationship is described above. The following describes a specific implementation in which the first unit obtains, based on the first mapping relationship, the compressed bitstream corresponding to the input data.

For determining of the first element based on the input data, optionally, the first element and the input data may satisfy any one of the following cases.

The first element is the input data. In this case, the input data may be a real-valued signal, and the first unit may block the input real-valued signal. An element in a vector corresponding to a blocked result (namely, a blocked real-valued signal) may be considered as the first element. Optionally, the first unit may block the input data based on a preconfigured or preset block size (for example, the block size may be denoted as $N_0$).

Alternatively, the first element is a real part and an imaginary part of the input data. In this case, the input data may be a complex-valued signal. The first unit may block the input complex-valued signal, and further concatenate the real part and the imaginary part of a blocked result (namely, a blocked complex-valued signal). An element in an obtained vector may be considered as the first element.

Alternatively, the first element is an element in an absolute value of the input data. In this case, the input data may be a real-valued signal or a complex-valued signal. If the input data is the complex-valued signal, the first unit may block the input complex-valued signal, concatenate a real part and an imaginary part of a blocked result (namely, a blocked complex-valued signal), and then perform splitting to obtain a sign bit vector and an absolute value vector. If the input data is the real-valued signal, the first unit may block the input real-valued signal, and directly split a blocked result (namely, a blocked real-valued signal) to obtain a sign bit vector and an absolute value vector. The first element may be considered as an element in the absolute value vector obtained through splitting. For example, the sign bit vector may be denoted as $C$, and the absolute value vector may be denoted as $A$.

Alternatively, the first element is an element in a vector obtained after the input data is normalized. In this case, the input data may be a complex-valued signal or real-valued signal. The first unit may block the input real-valued signal or complex-valued signal, and normalize a blocked result (namely, a blocked real-valued signal or complex-valued signal). An element in the vector corresponding to the obtained normalized result may be considered as the first element. Optionally, in this case, the first unit may further split the blocked result to obtain a sign bit vector and an absolute value vector, and then normalize the absolute value vector. For details about splitting the blocked result, refer to the foregoing descriptions. Details are not described herein again.

For example, the blocked result may be normalized based on a largest value of the blocked result, or the blocked result may be normalized based on a smallest value, a fixed value, or the like. This is not specifically limited in embodiments of this application.

For example, a normalization coefficient used to normalize the blocked result may be denoted as $a_{max}$. If the absolute value vector $A$ is normalized, an obtained normalized result may be denoted as $A'$, where $A'=A/a_{max}$.

Optionally, after blocking the input data, the first unit may further downsample a blocked result to obtain a downsampled result, and determine the first element based on the downsampled result. Specifically, the first unit may perform frequency domain compression on the blocked result based on a downsampling ratio (for example, the downsampling ratio may be denoted as $F_0$) to obtain a downsampled real-valued symbol or complex-valued symbol, and further determine the first element based on the downsampled real-valued symbol or complex-valued symbol. For example, the first unit may split and/or normalize the downsampled result.

For example, a quantity of the downsampled real-valued symbols or complex-valued symbols may be denoted as $M_0$, and $M_0=N_0F_0$, where $N_0$ is the block size, and $F_0$ is the downsampling ratio.

Downsampling and/or splitting performed by the first unit may be referred to as preprocessing.

Alternatively, the first unit may not downsample the blocked result. For example, the first unit may skip a downsampling operation when a bandwidth of the input data is consistent with a sampling rate of the input data (which may also be understood as skipping the downsampling operation when $F_0=1$).

Further, after obtaining the corresponding data bitstream based on the input data and the first mapping relationship, the first unit may perform packet assembly on the data bitstream and the frame header to obtain the compressed bitstream.

Optionally, the frame header may include information used to assist the second unit in restoring the compressed bitstream to obtain the reconstructed data. For example, the frame header may include information indicating the first parameter and/or information indicating the bit width.

Optionally, the information indicating the first parameter may directly indicate the value of the first parameter. Alternatively, the information indicating the first parameter may indicate a quantized value of the first parameter, for example, may include a bit value corresponding to the quantized value of the first parameter.

Generally, at least 16 bits or 32 bits are usually required if information is to indicate a real number. However, only three bits or four bits are usually required if the information indicates a quantized value of a real number. The first parameter is usually a real number. Therefore, compared with directly indicating the value of the first parameter, the information indicating the quantized value of the first parameter occupies fewer bits, and frame header overheads are smaller.

For the quantized value of the first parameter, in a possible implementation, if a distribution feature of the first parameter does not change greatly within a period of time, a mechanism for predicting the first parameter may be introduced to predict and quantize the first parameter. For example, the first parameter is the transform parameter ($P=\{\mu\}$) in Mu rate transform. It is assumed that the quantized value of the first parameter $P$ is indicated by using $b_P$ bits (bits). The first parameter may be quantized in the following manner to obtain the quantized value of the first parameter.

A value of $P$ at a moment is denoted as $\mu$. For example, $\mu_t$ indicates a value of $P$ at a moment $t$, and $\mu_{t-1}$ indicates a value of $P$ at a moment $t$-1. An initial value $\mu 0$ of P may be preset.

At moments t=1, 2, 3, ..., $\mu_t$ may be predicted and quantized based on the value of $\mu_{t-1}$. Specifically, $2^{b_P}$-1 quantization intervals may be selected near $\mu_{t-1}$. If a width of the quantization interval is set to $s_P$ in advance, the following quantization intervals may be obtained (where $\mu_{t-1}$ is used as a center):

$$\left[\mu_{t-1}-\frac{(2^{b_P}-1)s_P}{2},\ \mu_{t-1}-\frac{(2^{b_P}-3)s_P}{2}\right),\ \ldots,\ \left[\mu_{t-1}-\frac{3s_P}{2},\ \mu_{t-1}-\frac{s_P}{2}\right),\ \left[\mu_{t-1}-\frac{s_P}{2},\ \mu_{t-1}+\frac{s_P}{2}\right],\ \left(\mu_{t-1}+\frac{s_P}{2},\ \mu_{t-1}+\frac{3s_P}{2}\right],\ \ldots,\ \left(\mu_{t-1}+\frac{(2^{b_P}-3)s_P}{2},\ \mu_{t-1}+\frac{(2^{b_P}-1)s_P}{2}\right]$$

A midpoint of each quantization interval is a quantized value of $P$ at the moment $t$.

Optionally, if the first unit further normalizes the input data, the frame header may further include information indicating a normalization coefficient. Optionally, the information indicating the normalization coefficient may directly indicate a value of the normalization coefficient. Alternatively, the information indicating the normalization coefficient may indicate a quantized value of the normalization coefficient (a uniformly quantized value or a non-uniformly quantized value of the normalization coefficient), for example, may include a bit value corresponding to the quantized value of the normalization coefficient.

Generally, 12 bits to 16 bits of information may be required to indicate the original normalization coefficient, and after uniform/non-uniform quantization, only two bits to four bits of information may be required to indicate the quantized value of the normalization coefficient. Therefore, compared with directly indicating the value of the normalization coefficient, the information indicating the quantized value of the normalization coefficient occupies fewer bits, and frame header overheads are smaller.

For example, it is assumed that the quantized value of the normalization coefficient $a_{max}$ is indicated by using $b_{norm}$ bits (bits), the normalization coefficient may be uniformly quantized in the following Manner 1 to obtain the uniformly quantized value of the normalization coefficient, or the normalization coefficient may be non-uniformly quantized in the following Manner 2 to obtain the non-uniformly quantized value of the normalization coefficient.

Manner 1: The normalization coefficient is uniformly quantized based on quantization intervals [0, s], (s, 2s], (2s, 3s], ..., $((2^{b_{norm}}-1)s, 2^{b_{norm}}s]$, where a width of the quantization interval $s=2^{N_{data}-b_{norm}}$, and $N_{data}$ is the bit width of the input data before normalization.

Method 2: A quantized boundary $Q_b(a_{max})$ of $a_{max}$ is obtained based on a distribution feature of $a_{max}$, where a subscript $b$ of $Q$ indicates $b_{norm}$, $Q_b(a_{max})$ may also be referred to as a boundary of a value range of $a_{max}$, and $Q_b(a_{max})$ may be an upper limit or a lower limit of the non-uniformly quantized value of $a_{max}$, the quantization interval corresponding to $Q_b(a_{max})$ is non-uniform, and the non-uniformly quantized value of the normalization coefficient may be a midpoint of the quantization interval corresponding to $Q_b(a_{max})$.

Optionally, for Manner 2, $Q_b(a_{max})$ may use a nested representation manner in which the first mapping relationship is included in the second mapping relationship. For example, the first unit may store only $Q_b(a_{max})$ corresponding to a maximum value of $b_{norm}$, and $Q_b(a_{max})$ corresponding to other values of $b_{norm}$ may be obtained by extracting some stored values of $Q_b(a_{max})$. The maximum value of $b_{norm}$ may be obtained through calculation based on the block size, the bit width, and a frame header overhead ratio (the frame header overheads relative to overheads of a compressed bitstream frame structure).

Optionally, if the first unit further downsamples the input data, the frame header may further include information indicating a downsampling ratio.

Optionally, S303 may be further included after S302.

S303: The first unit sends the compressed bitstream to the second unit. Correspondingly, the second unit receives the compressed bitstream.

Further, after receiving the compressed bitstream, the second unit may decode the data bitstream in the compressed bitstream, and obtain the reconstructed data corresponding to the input data. Specifically, the second unit may dequantize the data bitstream in the compressed bitstream to obtain restored data, and obtain the reconstructed data based on the recovered data.

If the bit value of the data bitstream corresponding to the value range of the first element in the first mapping relationship is obtained by transforming the first element based on the first parameter corresponding to the first mapping relationship, and then quantizing a transformed result based on the bit width, when dequantizing the data bitstream in the compressed bitstream, the second unit may first dequantize the transformed result based on the bit width, and then inversely transform a dequantized result based on the first parameter to obtain the restored data.

For obtaining of the reconstructed data based on the restored data, if the first unit obtains the data bitstream based on the first mapping relationship without performing another operation on the blocked result when compressing the input data, the restored data is the reconstructed data. If the first unit performs another operation on the blocked result and then obtains the data bitstream based on the first mapping relationship, for example, downsamples, splits, and/or normalizes the blocked result, the second unit needs to perform corresponding inverse operations on the restored data after obtaining the restored data, to obtain the reconstructed data. For example, if the first unit downsamples, splits, and normalizes the blocked result, the second unit may inversely normalize the restored data, then concatenate obtained data into an original real number or complex-valued symbol, and perform an upsampling operation.

Optionally, the second unit may obtain the reconstructed data based on information included in the frame header in the compressed bitstream. For example, if the frame header includes the information indicating the first parameter, the second unit may inversely transform dequantized data based on the first parameter, to obtain the restored data. For another example, if the frame header includes the information indicating the normalization coefficient, the second unit may inversely normalize the restored data based on the normalization coefficient.

In the foregoing embodiment, the first unit can compress the input data based on the first mapping relationship. Compared with a current data compression method, this reduces a calculation amount and lowers complexity. However, the current data compression method also has the following disadvantages:

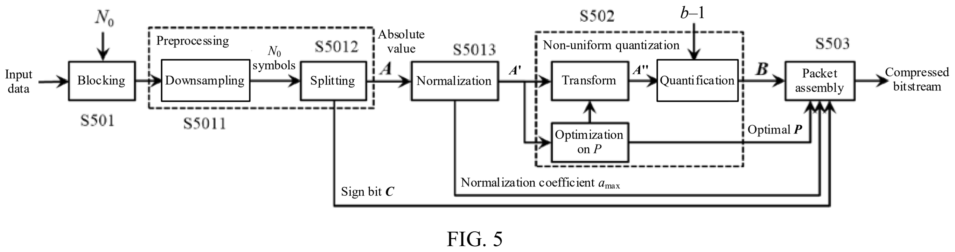

In the current data compression method, a data transmit end directly performs scaling and quantization after blocking, resulting in loss of valid information and reduction of compression precision. Moreover, when a scaling coefficient of each group of blocked data is calculated, a specific amount of data needs to be cached, and a cache size is consistent with a block size. Consequently, a specific delay is caused, and a larger block size causes a higher delay. To resolve this problem, an embodiment of this application further provides another method for compressing input data to obtain a compressed bitstream. The method may be understood as dynamic non-uniform quantization on the input data. As shown in FIG. 5, the method includes the following steps.

S501: A first unit blocks the input data.

The first unit blocks an input real-valued signal or complex-valued signal based on a block size, to obtain a blocked result.

For example, the block size may be denoted as $N_0$.

Optionally, the block size may be preconfigured, or may be configured by using signaling (for example, higher layer signaling, physical layer signaling, or other signaling), or may be configured by a receive end (namely, a second unit) of the compressed bitstream, or may be determined by the first unit based on related information, or may be determined in another manner. This is not limited in embodiments of this application.

For example, the first unit may calculate the block size $N_0$ in the following manner:

$$N_0 = \mathrm{floor}(\tau_{\max}/T_s) \qquad\qquad \text{Formula (5)}$$

Herein, floor($\tau_{\max}/T_s$) indicates that ($\tau_{\max}/T_s$) is rounded down, $\tau_{\max}$ indicates a maximum delay constraint, and $T_s$ indicates a sampling period of the input data.

Optionally, the maximum delay constraint may be an end-to-end processing delay of data, and mainly includes a delay and a calculation delay of cached data in a case in which the first unit blocks the data, and a calculation delay of decoding performed by the second unit. The maximum delay constraint may be related to a requirement of a service for a transmission delay. If the input data is data of a service that has a high delay requirement, the maximum delay constraint is also low.

Optionally, in a process of compressing the input data, the first unit may further preprocess the blocked result. For example, a preprocessing operation may include downsampling and/or splitting. As shown in FIG. 5, the first unit may perform S5011 after S501.

S5011: The first unit downsamples the blocked result.

In S5011, the first unit may perform frequency domain compression on the blocked result based on a downsampling ratio, to obtain downsampled real-valued symbols or complex-valued symbols.

For example, the downsampling ratio may be denoted as $F_0$. A quantity of downsampled real-valued symbols or complex-valued symbols may be denoted as $M_0$, $M_0=N_0F_0$, where $N_0$ is the block size.

Alternatively, the first unit may not downsample the blocked result. For example, the first unit may skip a downsampling operation when a bandwidth of the input data is consistent with a sampling rate of original data (which may also be understood as $F_0=1$).

Optionally, as shown in FIG. 5, the first unit may further perform S5012.

S5012: The first unit splits a downsampled result.

In S5012, if the downsampled result is a complex-valued signal, the first unit may concatenate a real part and an imaginary part of the downsampled result, and then perform splitting to obtain a sign bit vector (for example, the sign bit vector may be denoted as $C$) and an absolute value vector (for example, the absolute value vector may be denoted as $A$).

For example, it is assumed that the quantity of the downsampled real-valued symbols or complex-valued symbols is denoted as $M_0$. If the downsampled result is a real-valued signal, a length of an absolute value vector obtained through splitting may be denoted as $M_0$. If the downsampled result is the complex-valued signal, a length of the absolute value vector obtained through splitting may be denoted as $2M_0$.

Optionally, if the first unit does not downsample the blocked result, the first unit may also split the blocked result to obtain a sign bit vector and an absolute value vector.

Further, in a data bitstream obtained based on the absolute value vector obtained through splitting, a length of an absolute value part $B$ may be $M_0(b-1)$ (a length of the absolute value vector obtained through splitting is $M_0$, and $b$ is a bit width) or $2M_0(b-1)$ (a length of the absolute value vector obtained through splitting is $2M_0$).

Optionally, as shown in FIG. 5, the first unit may further perform S5013.

S5013: The first unit normalizes the absolute value vector based on a normalization coefficient to obtain a normalized result.

For example, the normalization coefficient may be denoted as $a_{max}$. If the absolute value vector $A$ is normalized, an obtained normalized result may be denoted as $A'$, where $A'=A/a_{max}$.

After the absolute value vector obtained through splitting is normalized, a value of the obtained normalized result is within [0, 1], and a value of a transform parameter may also be within [0, 1]. Therefore, the normalized result is more appropriate for transform based on the transform parameter.

Optionally, if the first unit downsamples the blocked result and does not split the blocked result, the first unit may also normalize the downsampled result. If the first unit does not downsample or split the blocked result, the first unit may also normalize the blocked result.

S502: The first unit non-uniformly quantizes the blocked result to obtain a data bitstream.

In S502, the first unit transforms the blocked result based on the transform parameter to obtain a transformed result. Further, the first unit may uniformly quantize the transformed result based on the bit width to obtain the data bitstream.

Because the bit width includes one sign bit, one sign bit needs to be removed during uniform quantization. For example, the transform parameter may be denoted as $P$. The bit width may be denoted as $b$. If a value of the transformed result ranges from 0 to 1, there are $2^{(b-1)}$ quantization intervals after one sign bit is removed from the bit width $b$. If the value of the transformed result ranges from 0 to 1, a width of each quantization interval is $1/2^{(b-1)}$.

The data bitstream includes a sign bit and binary absolute value information (or referred to as a binary bitstream of the absolute value part). For example, an absolute value part of the data bitstream may be denoted as $B$.

The transform parameter is a parameter of a nonlinear function. For example, the transform parameter may be a parameter related to CDF transform or Mu rate transform. It may be understood that because the transform parameter is the parameter of the nonlinear function, the blocked result can be non-uniformly quantized if the blocked result is transformed based on the transform parameter and then uniformly quantized.

For example, it is assumed that the blocked result is denoted as $A'$. If CDF transform is performed on $A'$, and a transformed result is denoted as $A''$, $A''$ may satisfy the following relationship:

$$\text{A}''[k] = \text{F}_{\text{A}'}(\text{A}'[k]) \qquad\qquad \text{Formula (6)}$$

Herein, $F_{A'}(\cdot)$ indicates a CDF of an element in $A'$, and $k$ indicates a $k^{th}$ piece of data in $A'$.

Further, for example, a random variable $x$ satisfies a Gaussian distribution. $F_{A'}(x)$ may satisfy the following relationship:

$$\text{F}_{\text{A}'}(x) = \frac{1}{\sigma\sqrt{2\pi}} \int_{-\infty}^{x} exp\left(-\frac{(t-\mu)^2}{2\sigma^2}\right) dt \qquad\qquad \text{Formula (7)}$$

Herein, $\mu$ and $\sigma^2$ are a mean value and a variance of the Gaussian distribution to which $x$ conforms, respectively. A transform parameter $P=\{\mu, \sigma^2\}$. The output result $A''$ (namely, the transformed result $A''$) conforms to a uniform distribution of [0, 1].

For another example, it is assumed that the blocked result is denoted as A'. If Mu rate transform is performed on A', and a transformed result is denoted as A", A" may satisfy the following relationship:

$$A''[k]=\ln(1+\mu A'[k])/\ln(1+\mu) \qquad\qquad \text{Formula (8)}$$

Herein, $\mu$ indicates a transform parameter in Mu rate transform. In other words, the transform parameter $P=\{\mu\}$. A value range of $\mu$ is (0, +∞), and a value range of the output result $A''$ (namely, the transformed result $A''$) is [0, 1]. When a value of $\mu$ is close to 0, $A''$ falls back to the original blocked result $A'$, that is, no transform is performed. When a value of $\mu$ is large, after the blocked result $A'$ is transformed, quantization precision of data with a small amplitude in $A'$ is improved.

Optionally, a value of the transform parameter used to transform the blocked result may be preset. Alternatively, before transforming the blocked result based on the transform parameter, the first unit may select a value from possible values of the transform parameter, and the first unit may transform the blocked result based on the selected value. It may also be understood as that the first unit selects the value of the transform parameter used to compress the input data this time.

Selection of the value of the transform parameter used to compress the input data this time from the possible values of the transform parameter may be referred to as online optimization of the transform parameter.

The possible value of the transform parameter may be preset, or may be determined from a preset value range, or may be determined in another manner. This is not limited in embodiments of this application.

It should be noted that a manner of online optimizing the transform parameter by the first unit is not limited in embodiments of this application. The following describes an example of online optimizing the transform parameter based on an optimization indicator.

The optimization indicator may be understood as an indicator that corresponds to a restored value obtained by dequantizing a data bitstream and that can represent (or be referred to as evaluate) reliability of the restored value. For example, the optimization indicator may include at least one of indicators such as a normalized mean square error, a generalized cosine similarity, a transmission throughput rate, and a bit error rate that correspond to the restored value obtained by dequantizing the data bitstream.

The first unit may determine, based on optimization indicators respectively corresponding to different values of the transform parameter, a value of the transform parameter that has a good optimization indicator as the value of the transform parameter used to compress the data this time. Specifically, the first unit may determine different data bitstreams obtained by transforming the input data based on the different values of the first parameter and then performing quantization, further determine restored values obtained by dequantizing the different data bitstreams, and calculate the optimization indicators corresponding to the restored values, to obtain the optimization indicators corresponding to the different values of the first parameter.

For example, if the optimization indicators are normalized mean square errors corresponding to the restored values obtained by dequantizing the data bitstreams, the first unit may determine a value of a transform parameter corresponding to a smallest normalized mean square error as the value of the transform parameter used to compress the input data this time. For another example, if the optimization indicators are generalized cosine similarities corresponding to the restored values obtained by dequantizing the data bitstreams, the first unit may determine a value of a transform parameter corresponding to a highest generalized cosine similarity as the value of the transform parameter used to compress the input data this time.

Optionally, a value of the bit width used to uniformly quantize the transformed result this time may be preconfigured, or may be configured by using signaling (for example, higher layer signaling, physical layer signaling, or other signaling), or may be configured by the second unit, or may be determined by the first unit based on related information, or may be determined in another manner. This is not limited in embodiments of this application. For details, refer to the foregoing descriptions of how to determine the value of the bit width in S302. Details are not described herein again.

Optionally, if the first unit may send the determined first parameter and/or bit width to the second unit, the second unit restores the compressed bitstream based on the first parameter and/or the bit width. In other words, the first unit and the second unit need to align the first parameter and/or the bit width used to compress the input data with the first parameter and/or the bit width used to restore the compressed bitstream.

S503: The first unit performs packet assembly to obtain the compressed bitstream.

In S503, the first unit performs packet assembly on the data bitstream and a frame header to obtain the compressed bitstream.

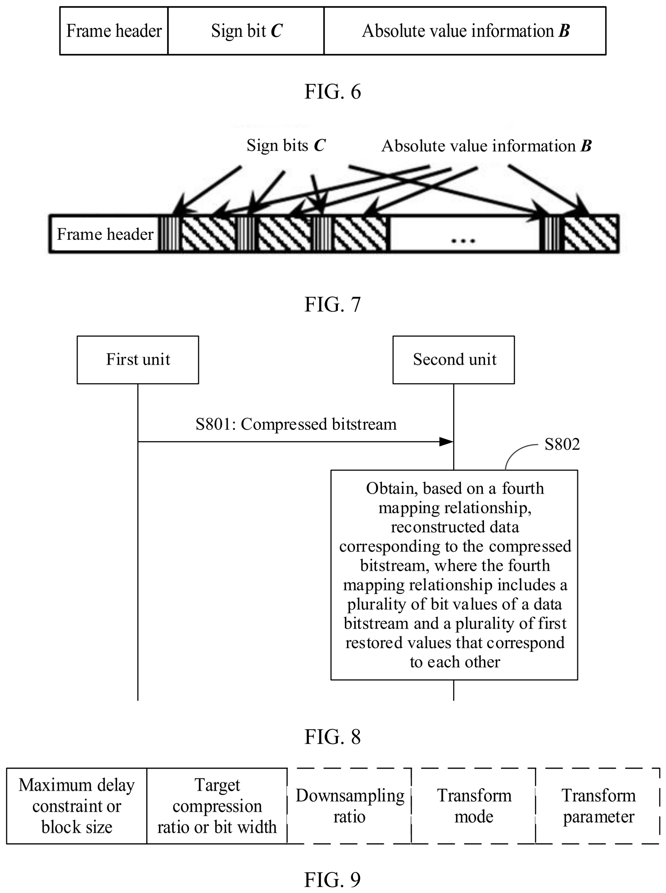

Optionally, the first unit may sequentially concatenate the frame header, sign bits (for example, denoted as $C$) of each piece of data in the data bitstream, and absolute value information (for example, denoted as $B$) of each piece of data in the data bitstream, to obtain the compressed bitstream. For example, FIG. 6 is a diagram of a structure of the compressed bitstream in this case.

Alternatively, the first unit may place the frame header at the forefront, and sequentially concatenate sign bits (for example, denoted as $C$) and absolute value information (for example, denoted as $B$) of pieces of real-valued data in the data bitstream, to obtain the compressed bitstream. For example, FIG. 7 is a diagram of a structure of the compressed bitstream in this case.

The frame header may include information used to assist the second unit in restoring the compressed bitstream to obtain information of reconstructed data. For example, the frame header may include information indicating the transform parameter and/or information indicating the bit width.

Optionally, the information indicating the transform parameter may directly indicate the value of the transform parameter. Alternatively, the information indicating the transform parameter may indicate a quantized value of the transform parameter, for example, may include a bit value corresponding to the quantized value of the transform parameter. For a specific implementation of indicating the quantized value of the transform parameter, refer to the foregoing descriptions of indicating the quantized value of the first parameter. Details are not described herein again.

Optionally, if the first unit normalizes the input data in a process of compressing the input data, the frame header in the compressed bitstream may further include information indicating a normalization coefficient. Optionally, the information indicating the normalization coefficient may directly indicate a value of the normalization coefficient, or may indicate a quantized value of the normalization coefficient, for example, may include a bit value corresponding to the quantized value of the normalization coefficient. For details, refer to the foregoing descriptions of the information indicating the normalization coefficient in S302. Details are not described herein again.

Further, the first unit may send the compressed bitstream to the second unit. Correspondingly, the second unit receives the compressed bitstream.

After receiving the compressed bitstream, the second unit may decode the data bitstream in the compressed bitstream, and obtain the corresponding reconstructed data. Specifically, the second unit may dequantize the data bitstream in the compressed bitstream based on the bit width, then inversely transforms data obtained through dequantization based on the transform parameter, to obtain the restored data, and then obtain the reconstructed data based on the restored data.

For a specific implementation in which the second unit obtains the reconstructed data based on the restored data, refer to the foregoing descriptions of S303. Details are not described herein again.

Optionally, the data compression method shown in FIG. 3 and the data compression method shown in FIG. 5 may be used in combination. In this case, the first unit determines the data bitstream based on the first mapping relationship, and the first unit performs non-uniform quantization based on the transform parameter to obtain the data bitstream, which may be replaced with each other, and both can compress the input data. The first parameter and the bit width that correspond to the first mapping relationship are the same as the transform parameter and the bit width used in a non-uniform quantization process.

It may be understood that if that the first unit performs non-uniform quantization based on the transform parameter to obtain the data bitstream in the data compression method shown in FIG. 5 is replaced with that the first unit determines the data bitstream based on the first mapping relationship, this can correspondingly reduce a calculation amount required by the first unit to transform the blocked result based on the transform parameter and further perform quantization, and lower complexity.

Currently, after receiving the compressed bitstream, a receive end needs to dequantize the data bitstream in the compressed bitstream through calculation. This requires a large calculation amount and has high complexity. Based on this problem, an embodiment of this application further provides a method for dequantizing a compressed bitstream at low complexity to obtain reconstructed data. As shown in FIG. 8, the method includes the following steps.

S801: A first unit sends a compressed bitstream to a second unit, and correspondingly, the second unit receives the compressed bitstream.

In S801, the compressed bitstream is obtained by the first unit by compressing input data based on a first parameter and a bit width. The compressed bitstream includes a data bitstream and a frame header.

Optionally, on a first unit side, the first parameter may be used to transform the input data, and the bit width may be used to uniformly quantize a transformed result. For details, refer to the foregoing descriptions of non-uniform quantization performed by the first unit based on the transform parameter and the bit width in S502. Details are not described herein again.

Optionally, the frame header may include information assisting the second unit in determining reconstructed data corresponding to the compressed bitstream. For example, the frame header may include information indicating the first parameter and/or information indicating the bit width. How the second unit determines, based on the first parameter and/or the bit width, the reconstructed data corresponding to the compressed bitstream is specifically described in S802. Details are not described herein.

Optionally, the information indicating the first parameter may directly indicate a value of the first parameter. Alternatively, the information indicating the first parameter may indicate a quantized value (a uniformly quantized value or a non-uniformly quantized value of the first parameter) of the first parameter, for example, may include a bit value corresponding to the quantized value of the first parameter. For details, refer to the foregoing descriptions of the information indicating the first parameter in S302. Details are not described herein again.

Optionally, the frame header may further include other information assisting the second unit in determining the reconstructed data corresponding to the compressed bitstream. For example, if the first unit normalizes the input data based on a normalization coefficient in a process of compressing the input data, the frame header may further include information indicating the normalization coefficient. The information indicating the normalization coefficient may directly indicate a value of the normalization coefficient. Alternatively, the information indicating the normalization coefficient may indicate a quantized value of the normalization coefficient (a non-uniformly quantized value or a uniformly quantized value), for example, may include a bit value corresponding to the quantized value of the normalization coefficient. For details, refer to the foregoing descriptions of the information indicating the normalization coefficient in S302. Details are not described herein again.

S802: The second unit obtains, based on a fourth mapping relationship, the reconstructed data corresponding to the compressed bitstream, where the fourth mapping relationship corresponds to the bit width and the first parameter, the fourth mapping relationship includes a plurality of bit values of a data bitstream and a plurality of first restored values that correspond to each other, and the first restored value is a result obtained by dequantizing the data bitstream.

It may be understood that the second unit can directly determine, based on the fourth mapping relationship, a first restored value corresponding to a bit value of a data bitstream, so that a calculation amount required for some operations (for example, dequantization) in a process of restoring the compressed data bitstream can be omitted, and restored data can be obtained, thereby lowering complexity.

In S802, the second unit may pre-obtain one or more fourth mapping relationships. If the second unit obtains one fourth mapping relationship, the fourth mapping relationship is the fourth mapping relationship used for the compressed bitstream this time.

If the second unit obtains a plurality of fourth mapping relationships, the second unit may determine a first parameter and a bit width that are used to restore the compressed bitstream this time, and further select the corresponding fourth mapping relationship based on the determined first parameter and bit width, to obtain the reconstructed data. In other words, on a second unit side, the bit width and the first parameter may be used to jointly determine the fourth mapping relationship.

For determining of the first parameter, optionally, the first parameter may be preconfigured, or the first parameter may be indicated by the frame header, or the first parameter may be configured by using signaling (for example, higher layer signaling, physical layer signaling, or other signaling), or may be determined by the second unit based on related information, or may be randomly determined by the second unit, or may be determined in another manner. This is not limited in embodiments of this application.

For determining of the bit width, optionally, the bit width may be preconfigured, or the bit width may be indicated by the frame header, or the bit width may be configured by using signaling (for example, higher layer signaling, physical layer signaling, or other signaling), or may be determined by the second unit based on related information, or may be randomly determined by the second unit, or may be determined in another manner. This is not limited in embodiments of this application.

Optionally, before S801, the second unit may send the determined first parameter and/or bit width to the first unit, so that the compressed bitstream sent by the first unit to the second unit is obtained by the first unit by compressing the input data based on the first parameter and/or bit width sent by the second unit. In other words, the first unit and the second unit need to align the first parameter and/or the bit width used to compress the input data with the first parameter and/or the bit width used to restore the compressed bitstream.

In S802, after receiving the compressed bitstream, the second unit may first interpret information included in the frame header, and then decode the data bitstream. The second unit may determine, based on a bit value of a read data bitstream, a first restored value corresponding to the bit value of the data bitstream in the fourth mapping relationship, determine the corresponding first restored value as restored data obtained by dequantizing the data bitstream, and obtain the reconstructed data based on the restored data.

If the first parameter is used on the first unit side to transform the input data, and the bit width is used to uniformly quantize a transformed result, the first restored value may be understood as a restored value obtained by dequantizing the data bitstream based on the bit width and then performing inverse transform based on the first parameter.

For details about how to obtain the reconstructed data based on the restored data, refer to the foregoing description of obtaining the reconstructed data by the second unit based on the restored data in S303. Details are not described herein again.

For example, when the first unit compresses the input data, if the first unit first blocks the input data, preprocesses (including down-samples and splits) a blocked result, performs normalization, and then non-uniformly quantizes a normalized result based on the first parameter and the bit width to obtain the data bitstream and performs packet assembly on the data bitstream to obtain the compressed bitstream, where the frame header includes the information indicating the first parameter and the information indicating the normalization coefficient (for details about how the first unit compresses the input data, refer to the foregoing descriptions of the data compression method shown in FIG. 4 or FIG. 5), after receiving the compressed bitstream, the second unit may first interpret frame header information to determine the first parameter and the normalization coefficient, then read the data bitstream, determine, based on the fourth mapping relationship corresponding to the first parameter and the bit width (which may be preset or determined in another manner), the first restored value corresponding to the bit value of the data bitstream, de-normalizes the first restored value based on the normalization coefficient, concatenate de-normalized data into an original real-valued or complex-valued symbol, and perform an upsampling operation to obtain the reconstructed data.

For example, it is assumed that the bit width corresponding to the fourth mapping relationship is 4, and the corresponding first parameter is a parameter $P$ related to Mu rate transform, where $P=\mu=2$. The fourth mapping relationship may be shown in Table 2.

Table 2

| Bit value of a data bitstream | 000 | 001 | 010 | 011 | 100 | 101 | 110 | 111 |
|---|---|---|---|---|---|---|---|---|
| First restored value | 0.025 | 0.075 | 0.15 | 0.275 | 0.425 | 0.6 | 0.775 | 0.925 |

It should be noted that a representation form of the fourth mapping relationship is not limited in embodiments of this application. The table form is merely an example of a representation form of the fourth mapping relationship. The fourth mapping relationship may also be in another representation form, for example, may be a string of digital sequences. The data sequences include the bit values of the data bitstream and the first restored values that are arranged in a specific order.

For obtaining of the fourth mapping relationship, optionally, the fourth mapping relationship may be preconfigured in the second unit. Alternatively, the fourth mapping relationship may be configured by using higher layer signaling, for example, may be configured by using MAC or RRC signaling. Alternatively, the fourth mapping relationship may be configured by using physical layer signaling, for example, may be configured by using PDCCH signaling. Alternatively, the fourth mapping relationship may be generated by the second unit. For example, the second unit may dynamically generate the fourth mapping relationship based on a current transmission configuration. A manner in which the second unit obtains the fourth mapping relationship is not limited in embodiments of this application.

Optionally, the method shown in FIG. 8 may be used in combination with the method shown in FIG. 3. In this case, the compressed bitstream sent by the first unit to the second unit may be obtained by the first unit by compressing the input data based on the first mapping relationship. In addition, the bit width and the first parameter that correspond to the first mapping relationship and that are used by the first unit are the same as the bit width and the first parameter that correspond to the fourth mapping relationship and that are used by the second unit. Alternatively, the method shown in FIG. 8 may be independently used. In this case, the compressed bitstream sent by the first unit to the second unit may be obtained by the first unit in any possible manner, for example, may be obtained by the first unit based on a compression procedure shown in FIG. 5.

Optionally, in the method shown in FIG. 3, the first mapping relationship may also include the plurality of bit values of the data bitstream and the plurality of the first restored values that correspond to each other. For the first restored value, refer to the foregoing descriptions of S802. Details are not described herein again.

Optionally, in the method shown in FIG. 8, the fourth mapping relationship may also include the plurality of bit values of the data bitstreams and a plurality of value ranges of the first element that correspond to each other. For the value range of the first element, refer to the foregoing descriptions of S302. Details are not described herein again.

Optionally, if the method shown in FIG. 8 is used in combination with the method shown in FIG. 3, where the first mapping relationship also includes the plurality of bit values of the data bitstream and the plurality of the first restored values that correspond to each other, and the fourth mapping relationship also includes the plurality of bit values of the data bitstreams and the plurality of value ranges of the first element that correspond to each other, the first mapping relationship and the fourth mapping relationship may be considered as a same mapping relationship, and the mapping relationship (referred to as a fifth mapping relationship below) includes the plurality of value ranges of the first element, the plurality of bit values of data bitstreams, and the plurality of first restored values that correspond to each other.

For example, it is assumed that a bit width corresponding to the fifth mapping relationship is 4, and a corresponding first parameter is a parameter $P$ related to Mu rate transform, where $P=\mu=2$. The fifth mapping relationship may be shown in Table 3.

Table 3

| Value range of the first element | [0, 0.05] | (0.05, 0.1] | (0.1, 0.2] | (0.2, 0.35] | (0.35, 0.5] | (0.5, 0.7] | (0.7, 0.85] | (0.85, 1] |
|---|---|---|---|---|---|---|---|---|
| Bit value of the data bitstream | 000 | 001 | 010 | 011 | 100 | 101 | 110 | 111 |
| First restored value | 0.025 | 0.075 | 0.15 | 0.275 | 0.425 | 0.6 | 0.775 | 0.925 |

It should be noted that a representation form of the fifth mapping relationship is not limited in embodiments of this application. The table form is merely an example of a representation form of the fifth mapping relationship. The fifth mapping relationship may also be in another representation form, for example, may be a string of digital sequences. The data sequences include the value ranges of the first element, the bit values of the data bitstream, and the first restored values that are arranged in a specific order.

Optionally, the first unit and/or the second unit may pre-obtain one or more fifth mapping relationships. For details about how to obtain the fifth mapping relationship, refer to the foregoing descriptions of obtaining the first mapping relationship/the fourth mapping relationship. Details are not described herein again.

Optionally, if the first unit and/or the second unit obtain/obtains the plurality of first mapping relationships, the fifth mapping relationship used to compress the input data this time or restore the compressed bitstream this time may be determined from a second mapping relationship based on the bit width and/or the first parameter, where the second mapping relationship includes boundaries of all the value ranges of the first element in the fifth mapping relationship. It may also be understood as that the fifth mapping relationship is nested in the second mapping relationship.

For a specific implementation of nesting the fifth mapping relationship in the second mapping relationship, refer to the foregoing descriptions of nesting the first mapping relationship in the second mapping relationship. Details are not described herein again.

Optionally, the following describes several possible manners in which the first unit or the second unit determines compression parameter information (which may also be referred to as that the first unit or the second unit configures compression parameter information) in the foregoing embodiments. The compression parameter information includes parameters related to compressing the input data. The first unit may compress the input data based on the compression parameter information to obtain the compressed bitstream. The second unit may restore the compressed bitstream based on the compression parameter information to obtain the reconstructed data.

Optionally, the compression parameter information may be configured before the first unit compresses the input

data.

For example, the compression parameter information may include at least one of the following: a block size, a target compression ratio, the bit width, a downsampling ratio, a transform mode, a transform parameter, the first parameter, a boundary of the value range of the first element, or a boundary of a value range of the normalization coefficient.

For details about the block size, the target compression ratio, the bit width, the downsampling ratio, the transform parameter, the first parameter, the boundary of the value range of the first element, and the boundary of the value range of the normalization coefficient, refer to the foregoing descriptions. Details are not described herein again. The transform mode is information about a mode used to transform the blocked result based on the transform parameter. For example, if CDF transform is performed on the blocked result based on the transform parameter, the transform mode is information indicating a CDF transform mode.

The following uses an example in which the first unit determines compression parameter information to describe a manner of determining the compression parameter information. The first unit may determine the compression parameter information based on at least one of the following manners.

Manner 1: The first unit determines the compression parameter information based on a first transmission configuration.

In Manner 1, the first transmission configuration is related to a signal bandwidth and/or a quantity of signal transmission streams. In other words, the first unit may determine the compression parameter information based on the transmission configuration related to the signal bandwidth and/or the quantity of signal transmission streams.

For example, the first unit may determine the block size based on a maximum delay constraint. A relationship between the maximum delay constraint and the block size may be shown in Formula (2), and details are not described herein again.

For another example, the first unit may determine the target compression ratio or the bit width based on the current first transmission configuration. For example, when the signal bandwidth is high, the first unit may determine a high target compression ratio or determine a small bit width. When the signal bandwidth is low, the first unit may determine a low target compression ratio or determine a large bit width.

For another example, after determining the target compression ratio based on the current first transmission configuration, the first unit may further determine the bit width based on the target compression ratio. A relationship between the target compression ratio and the bit width may be shown in Formula (1), and details are not described herein again.

For another example, the first unit may determine that the downsampling ratio=baseband signal bandwidth/-sampling bandwidth based on bandwidth parameters in the current first transmission configuration, for example, the baseband signal bandwidth and the sampling bandwidth.

For another example, compression parameter information corresponding to different first transmission configurations may be preset. The preset compression parameter information may be compression parameter information that can be used to obtain a compressed bitstream with good performance (for example, less distortion and less required transmission bandwidth) in a corresponding first transmission configuration.

Manner 2: The first unit obtains a third mapping relationship, where the third mapping relationship includes a second transmission configuration and the compression parameter information that correspond to each other. The second transmission configuration is a transmission configuration related to a modulation and coding scheme of a signal.

In Manner 2, the first unit may pre-obtain one or more third mapping relationships. After determining the second transmission configuration currently used, the first unit may query the corresponding compression parameter information in the third mapping relationship including the second transmission configuration.

The second transmission configuration may be the transmission configuration related to the modulation and coding scheme of the signal in a wireless transmission configuration in the first unit. For example, the second transmission configuration may include a transmission configuration like a modulation and coding scheme (modulation and coding scheme, MCS) or a quadrature amplitude modulation (quadrature amplitude modulation, QAM) order.

Optionally, the third mapping relationship may be preconfigured in the first unit. Alternatively, the third mapping relationship may be configured by using higher layer signaling, for example, may be configured by using MAC or RRC signaling. Alternatively, the third mapping relationship may be configured by using physical layer signaling, for example, may be configured by using PDCCH signaling. Alternatively, the third mapping relationship may be generated by the first unit. For example, the first unit may dynamically generate the third mapping relationship based on a current transmission configuration. A manner in which the first unit obtains the third mapping relationship is not limited in embodiments of this application.

For example, the third mapping relationship may be shown in Table 4. The second transmission configuration is the MCS, and includes binary phase shift keying (binary phase shift keying, BPSK), quadrature phase shift keying (quadrature phase shift keying, QPSK), and a QAM order.

Table 4

| MCS | Compression parameter | | |
|---|---|---|---|
| | Bit width | Boundary of the value range of the first element | Boundary of the value range of the normalization coefficient |
| BPSK, 1/2 rate (rate) | 3 | $Q_3(P_3)$ | $Q_3(a_{max})$ |
| QPSK, 1/2 rate | 4 | $Q_4(P_4)$ | $Q_4(a_{max})$ |
| QPSK, 3/4 rate | 5 | $Q_5(P_5)$ | $Q_5(a_{max})$ |
| 16QAM, 3/4 rate | 6 | $Q_6(P_6)$ | $Q_6(a_{max})$ |
| 64QAM, 3/4 rate | 7 | $Q_7(P_7)$ | $Q_7(a_{max})$ |
| 64QAM, 7/8 rate | 8 | $Q_8(P_8)$ | $Q_8(a_{max})$ |
| 256QAM, 3/4 rate | 9 | $Q_9(P_9)$ | $Q_9(a_{max})$ |
| 256QAM, 7/8 rate | 10 | $Q_{10}(P_{10})$ | $Q_{10}(a_{max})$ |

In Table 4, the boundary of the value range of the first element is denoted as $Q_b(P_b)$, where $b$ indicates the bit width, and $P$ indicates the first parameter or the transform parameter. The boundary of the value range of the normalization coefficient is denoted as $Q_b(a_{max})$, where $a_{max}$ indicates the normalization coefficient, and $b$ indicates the bit width. In Table 4, $P_3$, $P_4$, ..., $P_{10}$ may have a same value, or may have different values.

Manner 3: The first unit receives the compression parameter information.

In this manner, the first unit may receive the compression parameter information from the second unit. Alternatively, the first unit may receive the compression parameter information from another device.

Optionally, if the first unit determines the compression parameter information in the foregoing Manner 1 or Manner 2, the first unit may send the compression parameter information to the second unit, so that the second unit aligns the compression parameter information with the first unit.

Optionally, if the first unit determines the compression parameter information in the foregoing Manner 1 or Manner 2, the first unit may dynamically update the compression parameter information when the first transmission configuration or the second transmission configuration changes. For example, if a new first transmission configuration or a new second transmission configuration is configured in RRC signaling received by the first unit, the first unit may be triggered to update the compression parameter information based on the new first transmission configuration or the new second transmission configuration.

Optionally, if the compression parameter information includes the target compression ratio, after the first unit sends the target compression ratio to the second unit, the second unit may determine the bit width based on the target compression ratio and a preset formula/algorithm (for example, the foregoing Formula (4)). The first unit and the second unit may be preconfigured with the same formula/algorithm for determining the bit width based on the target compression ratio, so that the first unit and the second unit can determine the same bit width based on the same target compression ratio.

Optionally, if the first unit determines the block size based on the maximum delay constraint, the first unit may send the maximum delay constraint to the second unit. The second unit may determine the block size based on the maximum delay constraint and a preset formula/algorithm (for example, the foregoing Formula (5)). The first unit and the second unit may be preconfigured with the same formula/algorithm for determining the block size based on the maximum delay constraint, so that the first unit and the second unit can determine the same block size based on the same maximum delay constraint.

For example, a structure of the compression parameter information sent by the first unit to the second unit may be shown in FIG. 9. The compression parameter information includes the maximum delay constraint $\tau_{max}$ or the block size $N_0$, the target compression ratio $D$, or the bit width $b$. Optionally, the compression parameter information may further include the downsampling ratio $F_0$, the transform mode $I_{trans}$, and the transform parameter $P$.

In the foregoing embodiment, for a manner in which the second unit determines the compression parameter information, refer to the foregoing descriptions of how the first unit determines the compression parameter information. Details are not described herein again. If the second unit receives the compression parameter information, the second unit may receive the compression parameter information from the first unit. Alternatively, the first unit may receive the compression parameter information from another device.

Optionally, if the compression parameter information sent by the first unit to the second unit includes the first parameter or the transform parameter, or the compression parameter information determined by the second unit includes the first parameter or the transform parameter, the frame header in the compressed bitstream sent by the first unit to the second unit may not include information indicating the first parameter or indicating the transform parameter.

Optionally, if the first unit or the second unit does not determine the downsampling ratio, the downsampling ratio may be a default value, for example, may be a default value 1.

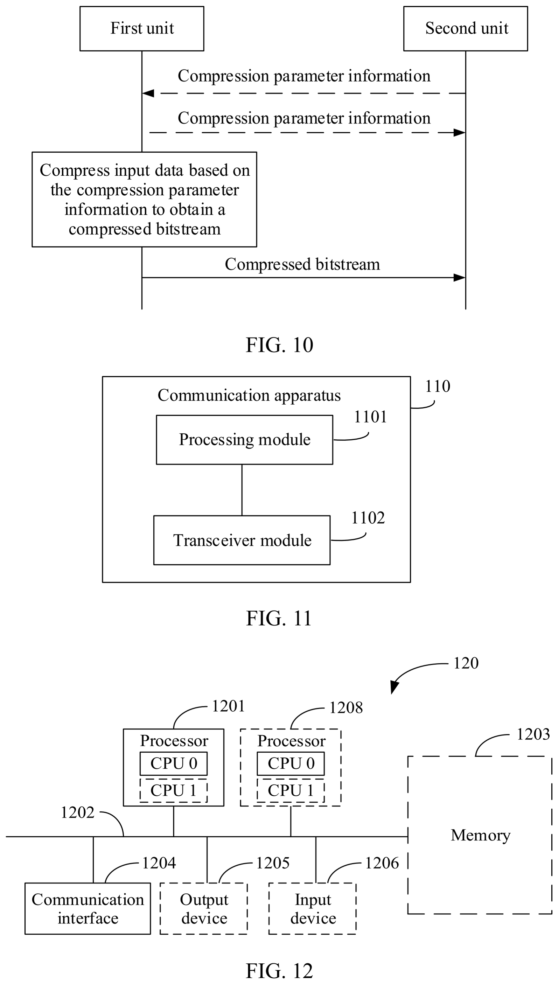

For example, a procedure of configuring compression parameter information between a first unit and a second unit may be shown in FIG. 10. The first unit sends the compression parameter information to the second unit, or the second unit sends the compression parameter information to the first unit. For a manner of determining the compression parameter information sent by the first unit or the second unit, refer to the foregoing Manner 1 or Manner 2. After the compression parameter information is configured, the first unit sends a compressed bitstream to the second unit. The compressed bitstream is obtained by compressing input data based on the compression parameter information.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

It may be understood that, in the foregoing embodiments, methods and/or steps implemented by each unit may alternatively be implemented by a component (for example, a processor, a chip, a chip system, a circuit, a logic module, or software, for example, a chip or a circuit) that may be used in the unit.

The foregoing mainly describes the solutions provided in this application from a perspective of interaction between units. Correspondingly, this application further provides a communication apparatus. The communication apparatus is configured to implement the foregoing methods. The communication apparatus may be the first unit or the second unit in the foregoing method embodiments, an apparatus including the foregoing device, or a component that may be used in the foregoing device.

It may be understood that, to implement the foregoing functions, the communication apparatus includes a hardware structure and/or a software module for performing a corresponding function. A person skilled in the art should easily be aware that, in combination with units and algorithm steps of the examples described in embodiments disclosed in this specification, this application may be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, functional modules of the communication apparatus may be obtained through division based on the foregoing method embodiments. For example, functional modules may be obtained through division in correspondence to functions, or at least two functions may be integrated into one processing module. The integrated module may be implemented in a form of hardware, or may be implemented in a form of a software functional module. It should be noted that, in embodiments of this application, division into the modules is an example, and is merely a logical function division. In actual implementation, another division manner may be used.

FIG. 11 is a diagram of a structure of a communication apparatus 110. For example, as shown in FIG. 11, the communication apparatus 110 includes a transceiver module 1102 and a processing module 1101. For ease of description, FIG. 11 shows only main components of the communication apparatus.

In some embodiments, the communication apparatus 110 may further include a storage module (not shown in FIG. 11), configured to store program instructions and data.

In some embodiments, the transceiver module 1102 may also be referred to as a transceiver unit, and is configured to implement a sending and/or receiving function. The transceiver module 1102 may include a transceiver circuit, a transceiver machine, a transceiver, or a communication interface.

In some embodiments, the transceiver module 1102 may include a receiving module and a sending module, respectively configured to perform receiving and sending steps performed by the first unit or the second unit in the foregoing method embodiments, and/or configured to support other processes of the technology described in this specification. The processing module 1101 may be configured to perform processing steps (for example, determining and generation) performed by the first unit or the second unit in the foregoing method embodiments, and/or configured to support other processes of the technology described in this specification.

When the communication apparatus 110 is configured to implement the function of the first unit:

In a possible design, the processing module 1101 is configured to obtain input data to be compressed. The processing module 1101 is further configured to obtain a compressed bitstream based on a first mapping relationship, where the first mapping relationship corresponds to a bit width and a first parameter, the first mapping relationship includes a plurality of value ranges of a first element and a plurality of bit values of a data bitstream that correspond to each other, the first element is determined based on the input data, the data bitstream is a binary bitstream corresponding to a value range of the first element, a value of the bit width is related to a quantity of bits of a bit value of the data bitstream, and the first parameter is used to determine the value range of the first element.

Optionally, that the processing module 1101 obtains the compressed bitstream based on the first mapping relationship includes: blocking the input data to obtain a blocked result; determining, based on the first mapping relationship, a data bitstream corresponding to the blocked result; and performing packet assembly on the data bitstream and a frame header to obtain the compressed bitstream, where the frame header includes information indicating the first parameter.

Optionally, the processing module 1101 is further configured to normalize the blocked result based on a normalization coefficient, to obtain a normalized result. That the processing module 1101 determines, based on the first mapping relationship, the data bitstream corresponding to the blocked result includes: determining, based on the first mapping relationship, the data bitstream corresponding to the normalized result.

Optionally, the processing module 1101 is further configured to determine compression parameter information based on a first transmission configuration, where the first transmission configuration is related to a signal bandwidth and/or a quantity of signal transmission streams, and the compression parameter information includes at least one of the following: a block size, a target compression ratio, the bit width, a downsampling ratio, a transform mode, the first parameter, a boundary of the value range of the first element, or a boundary of a value range of the normalization coefficient.

Optionally, the processing module 1101 is further configured to obtain a third mapping relationship, where the third mapping relationship includes a second transmission configuration and compression parameter information that correspond to each other, the second transmission configuration is related to a modulation and coding scheme of a signal, and the compression parameter information includes at least one of the following: a block size, a target compression ratio, the bit width, a downsampling ratio, a transform mode, the first parameter, a boundary of the value range of the first element, or a boundary of a value range of the normalization coefficient.

Optionally, the transceiver module 1102 is configured to receive compression parameter information, where the compression parameter information includes at least one of the following: a block size, a target compression ratio, the bit width, a downsampling ratio, a transform mode, the first parameter, a boundary of the value range of the first element, or a boundary of a value range of the normalization coefficient.

Optionally, the transceiver module 1102 is configured to send the compression parameter information, where the compression parameter information includes the at least one of the following: the block size, the target compression ratio, the bit width, the downsampling ratio, the transform mode, the first parameter, the boundary of the value range of the first element, or the boundary of the value range of the normalization coefficient.

When the communication apparatus 110 is configured to implement the function of the second unit:

The transceiver module 1102 is configured to receive a compressed bitstream, where the compressed bitstream includes a frame header and a data bitstream. The processing module 1101 is configured to obtain, based on a fourth mapping relationship, reconstructed data corresponding to the compressed bitstream, where the fourth mapping relationship corresponds to a bit width and a first parameter, the fourth mapping relationship includes a plurality of bit values of a data bitstream and a plurality of first restored values that correspond to each other, and the first restored value is a result obtained by dequantizing the data bitstream.

Optionally, the frame header further includes information indicating a normalization coefficient. That the processing module 1101 obtains, based on the fourth mapping relationship, the reconstructed data corresponding to the compressed bitstream includes: obtaining, based on the fourth mapping relationship, a restored value corresponding to the data bitstream in the compressed bitstream; de-normalizing the restored value based on the normalization coefficient to obtain reconstructed data.

Optionally, the processing module 1101 is further configured to determine compression parameter information based on a first transmission configuration, where the first transmission configuration is related to a signal bandwidth and/or a quantity of signal transmission streams, and the compression parameter information includes at least one of the following: a block size, a target compression ratio, the bit width, a downsampling ratio, a transform mode, the first parameter, a boundary of a value range of the first element, or a boundary of a value range of the normalization coefficient.

Optionally, the processing module 1101 is further configured to obtain a third mapping relationship, where the third mapping relationship includes a mapping relationship between a second transmission configuration and compression parameter information, the second transmission configuration is related to a modulation and coding scheme of a signal, and the compression parameter information includes at least one of the following: a block size, a target compression ratio, the bit width, a downsampling ratio, a transform mode, the first parameter, a boundary of a value range of the first element, or a boundary of a value range of the normalization coefficient.

Optionally, the transceiver module 1102 is further configured to receive compression parameter information, where the compression parameter information includes at least one of the following: a block size, a target compression ratio, the bit width, a downsampling ratio, a transform mode, the first parameter, a boundary of a value range of the first element, or a boundary of a value range of the normalization coefficient.

Optionally, the transceiver module 1102 is further configured to send the compression parameter information, where the compression parameter information includes the at least one of the following: the block size, the target compression ratio, the bit width, the downsampling ratio, the transform mode, the first parameter, the boundary of the value range of the first element, or the boundary of the value range of the normalization coefficient.

All related content of the steps in the foregoing method embodiments may be cited in function descriptions of the corresponding functional modules. Details are not described herein again.

In this application, the communication apparatus 110 is presented in a form of dividing functional modules in an integrated manner. The "module" herein may be an application-specific integrated circuit (application-specific integrated circuit, ASIC), a circuit, a processor that executes one or more software programs or firmware programs, a memory, an integrated logic circuit, and/or another component that can provide the foregoing function.

In some embodiments, when the communication apparatus 110 in FIG. 11 is a chip or a chip system, a function/implementation process of the transceiver module 1102 may be implemented by using an input/output interface (or a communication interface) of the chip or the chip system, and a function/implementation process of the processing module 1101 may be implemented by using a processor (or a processing circuit) of the chip or the chip system.

The communication apparatus 110 provided in this embodiment may perform the foregoing methods. Therefore, for technical effect that can be achieved by the communication apparatus 110, refer to the foregoing method embodiments. Details are not described herein again.

In another possible product form, the communication apparatus 110 may alternatively be implemented by using the following: one or more field programmable gate arrays (field programmable gate arrays, FPGAs), a programmable logic device (programmable logic device, PLD), a controller, a state machine, gate logic, a discrete hardware component, any other suitable circuit, or any combination of circuits that can perform various functions described in this application.

It should be noted that the structure shown in FIG. 11 does not constitute a specific limitation on a device structure. For example, in some other embodiments of this application, the device may include more or fewer components than those shown in the figure, some components may be combined, some components may be split, or the components may be differently arranged. The components shown in the figure may be implemented by hardware, software, or a combination of software and hardware.

In some embodiments, an embodiment of this application further provides a communication apparatus. The communication apparatus includes a processor, configured to implement the method in any one of the foregoing method embodiments.

In a possible implementation, the communication apparatus further includes a memory. The memory is configured to store a necessary computer program and data. The computer program may include instructions. The processor may invoke the instructions in the computer program stored in the memory, to instruct the communication apparatus to perform the method in any foregoing method embodiment. Certainly, the communication apparatus may not include a memory.

In another possible implementation, the communication apparatus further includes an interface circuit. The interface circuit is a code/data read/write interface circuit, and the interface circuit is configured to receive computer-executable instructions (where the computer-executable instructions are stored in a memory, and may be directly read from the memory, or may be read via another component) and transmit the computer-executable instructions to the processor.

In still another possible implementation, the communication apparatus further includes a communication interface, and the communication interface is configured to communicate with a module other than the communication apparatus.

It may be understood that the communication apparatus may be a chip or a chip system. When the communication apparatus is the chip system, the communication apparatus may include a chip, or may include a chip and another discrete component. This is not specifically limited in embodiments of this application.

For example, the communication apparatus may use a structure of a communication apparatus 120 shown in FIG. 12. As shown in FIG. 12, the communication apparatus 120 includes a processor 1201, a communication line 1202, and at least one communication interface (FIG. 12 shows merely an example in which a communication interface 1204 is included for description). Optionally, the communication apparatus 120 may further include a memory 1203.

The processor 1201 may be a general-purpose central processing unit (central processing unit, CPU), a microprocessor, an ASIC, or one or more integrated circuits configured to control program execution of the solutions of this application.

The communication line 1202 may include a path, and transfer information between the foregoing components.

The communication interface 1204 uses any transceiver apparatus to communicate with another device or communication network, for example, an Ethernet, a radio access network, or a wireless local area network (wireless local area network, WLAN).

The memory 1203 may be a read-only memory (read-only memory, ROM) or another type of static storage device that can store static information and instructions, or a random access memory (random access memory, RAM) or another type of dynamic storage device that can store information and instructions. Alternatively, the memory 1203 may be an electrically erasable programmable read-only memory (electrically erasable programmable read-only memory, EEPROM), a compact disc read-only memory (compact disc read-only memory, CD-ROM) or another compact disc storage, an optical disc storage (including a compact disc, a laser disc, an optical disc, a digital versatile disc, a Blu-ray optical disc, and the like), a magnetic disk storage medium or another magnetic storage device, or any other medium that can be used to carry or store expected program code in a form of instructions or a data structure and that can be accessed by a computer. However, the memory 1203 is not limited thereto. The memory may exist independently, and is connected to the processor through the communication line 1202. The memory may alternatively be integrated with the processor.

The memory 1203 is configured to store computer-executable instructions for performing the solutions of this application, and the processor 1201 controls execution. The processor 1201 is configured to execute the computer-executable instructions stored in the memory 1203, to implement the methods provided in the foregoing embodiments of this application.

Optionally, the computer-executable instructions in embodiments of this application may also be referred to as application program code or computer program code. This is not specifically limited in embodiments of this application.

In a specific implementation, in an embodiment, the processor 1201 may include one or more CPUs, for example, a CPU 0 and a CPU 1 in FIG. 12.

In a specific implementation, in an embodiment, the communication apparatus 120 may include a plurality of processors, for example, the processor 1201 and a processor 1208 in FIG. 12. Each of the processors may be a single-core (single-CPU) processor, or may be a multi-core (multi-CPU) processor. The processor herein may be one or more devices, circuits, and/or processing cores configured to process data (for example, computer program instructions).

In a specific implementation, in an embodiment, the communication apparatus 120 may further include an output device 1205 and an input device 1206. The output device 1205 communicates with the processor 1201, and can display information in a plurality of manners. For example, the output device 1205 may be a liquid crystal display (liquid crystal display, LCD), a light emitting diode (light emitting diode, LED) display device, a cathode ray tube (cathode ray tube, CRT) display device, or a projector (projector). The input device 1206 communicates with the processor 1201, and may receive a user input in a plurality of manners. For example, the input device 1206 may be a mouse, a keyboard, a touchscreen device, or a sensing device.

It may be understood that the structure shown in FIG. 12 does not constitute a specific limitation on the communication apparatus 120. For example, in some other embodiments of this application, the communication apparatus 120 may include more or fewer components than those shown in the figure, some components may be combined, some components may be split, or the components may be differently arranged. The components shown in the figure may be implemented by hardware, software, or a combination of software and hardware.

The communication apparatus 120 provided in this embodiment may perform the foregoing data compression method. Therefore, for technical effect that can be achieved by the communication apparatus 120, refer to the foregoing method embodiments. Details are not described herein again.

In a simple embodiment, a person skilled in the art may figure out that the communication apparatus 110 may be in a form of the communication apparatus 120 shown in FIG. 12.

Specifically, functions/implementation processes of the transceiver module 1102 and the processing module 1101 in FIG. 11 may be implemented by invoking, by the processor 1201 shown in FIG. 12, the computer-executable instructions stored in the memory 1203. Alternatively, a function/an implementation process of the processing module 1101 in FIG. 11 may be implemented by invoking, by the processor 1201 shown in FIG. 12, the computer-executable instructions stored in the memory 1203, and a function/an implementation process of the transceiver module 1102 in FIG. 11 may be implemented by using the communication interface 1204 shown in FIG. 12.

This application further provides a computer-readable storage medium. The computer-readable storage medium stores a computer program or instructions. When the computer program or instructions are executed by a computer, functions in any foregoing method embodiment are implemented.

This application further provides a computer program product. When the computer program product is executed by a computer, functions in any foregoing method embodiment are implemented.

A person of ordinary skill in the art may understand that, for the purpose of convenient and brief description, for a detailed working process of the foregoing system, apparatuses, and units, refer to a corresponding process in the foregoing method embodiments. Details are not described herein again.

It may be understood that the system, apparatuses, and methods described in this application may alternatively be implemented in another manner. For example, the described apparatus embodiments are merely examples. For example, division into the units is merely logical function division. There may be another division manner during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may be physically or not physically separated. To be specific, the units may be located at a same place or distributed on a plurality of network units. Parts displayed as units may be or may be not physical units. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit.

All or some of the foregoing embodiments may be implemented by software, hardware, firmware, or any combination thereof. When a software program is used to implement embodiments, embodiments may be implemented completely or partially in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (solid-state disk, SSD)), or the like. In embodiments of this application, the computer may include the foregoing apparatuses.

Although this application is described with reference to embodiments, in a process of implementing this application that claims protection, a person skilled in the art may understand and implement another variation of the disclosed embodiments by viewing the accompanying drawings, disclosed content, and appended claims. In the claims, "comprising" (comprising) does not exclude another component or another step, and "a" or "one" does not exclude a case of multiple. A single processor or another unit may implement several functions enumerated in the claims. Some measures are recorded in dependent claims that are different from each other, but this does not mean that these measures cannot be combined to produce better effect.

Although this application is described with reference to specific features and embodiments thereof, it is clear that various modifications and combinations may be made to them without departing from the spirit and scope of this application. Correspondingly, the specification and accompanying drawings are merely example description of this application defined by the appended claims, and are considered as any of or all modifications, variations, combinations or equivalents that cover the scope of this application. It is clear that a person skilled in the art can make various modifications and variations to this application without departing from the spirit and scope of this application. This application is intended to cover these modifications and variations of this application provided that they fall within the scope of protection defined by the following claims and their equivalent technologies.

**Claims**

1. A data compression method, wherein the method comprises:

   obtaining input data to be compressed; and
   obtaining a compressed bitstream based on a first mapping relationship, wherein the first mapping relationship corresponds to a bit width and a first parameter, the first mapping relationship comprises a plurality of value ranges of a first element and a plurality of bit values of a data bitstream that correspond to each other, the first element is determined based on the input data, the data bitstream is a binary bitstream corresponding to a value range of the first element, a value of the bit width is related to a quantity of bits of a bit value of the data bitstream, and the first parameter is used to determine the value range of the first element.

2. The method according to claim 1, wherein that the first element is determined based on the input data comprises:

   the first element is the input data; or
   the first element is a real part and an imaginary part of the input data; or
   the first element is an element in an absolute value of the input data; or
   the first element is an element in a vector obtained after the input data is normalized.

3. The method according to claim 1 or 2, wherein
   the first mapping relationship is determined from a second mapping relationship based on the bit width and/or the first parameter, and the second mapping relationship comprises boundaries of all the value ranges of the first element in the first mapping relationship.

4. The method according to any one of claims 1 to 3, wherein the first mapping relationship further comprises the plurality of bit values of the data bitstream and a plurality of first restored values that correspond to each other, and the first restored value is a result obtained by dequantizing the data bitstream.

5. The method according to any one of claims 1 to 4, wherein obtaining the compressed bitstream based on the first mapping relationship comprises:

blocking the input data to obtain a blocked result;
determining, based on the first mapping relationship, a data bitstream corresponding to the blocked result; and
performing packet assembly on the data bitstream and a frame header to obtain the compressed bitstream, wherein the frame header comprises information indicating the first parameter.

6. The method according to claim 5, wherein after obtaining the blocked result, the method further comprises:

normalizing the blocked result based on a normalization coefficient to obtain a normalized result; and
determining, based on the first mapping relationship, the data bitstream corresponding to the blocked result comprises:
determining, based on the first mapping relationship, a data bitstream corresponding to the normalized result.

7. The method according to claim 6, wherein the frame header further comprises information indicating the normalization coefficient, and the information indicating the normalization coefficient indicates a uniformly quantized value or a non-uniformly quantized value of the normalization coefficient.

8. The method according to any one of claims 5 to 7, wherein the information indicating the first parameter indicates a quantized value of the first parameter.

9. The method according to any one of claims 1 to 8, wherein the first parameter is determined based on an optimization indicator, and the optimization indicator comprises at least one of a normalized mean square error NMSE, a generalized cosine similarity GCS, a transmission throughput, and a bit error rate that correspond to a restored value obtained by dequantizing the data bitstream.

10. The method according to any one of claims 1 to 9, wherein the method further comprises:
determining compression parameter information based on a first transmission configuration, wherein the first transmission configuration is related to a signal bandwidth and/or a quantity of signal transmission streams, and the compression parameter information comprises at least one of the following: a block size, a target compression ratio, the bit width, a downsampling ratio, a transform mode, the first parameter, a boundary of the value range of the first element, or a boundary of a value range of the normalization coefficient.

11. The method according to any one of claims 1 to 9, wherein the method further comprises:
obtaining a third mapping relationship, wherein the third mapping relationship comprises a second transmission configuration and compression parameter information that correspond to each other, the second transmission configuration is related to a modulation and coding scheme of a signal, and the compression parameter information comprises at least one of the following: a block size, a target compression ratio, the bit width, a downsampling ratio, a transform mode, the first parameter, a boundary of the value range of the first element, or a boundary of a value range of the normalization coefficient.

12. The method according to any one of claims 1 to 9, wherein the method further comprises:
receiving compression parameter information, wherein the compression parameter information comprises at least one of the following: a block size, a target compression ratio, the bit width, a downsampling ratio, a transform mode, the first parameter, a boundary of the value range of the first element, or a boundary of a value range of the normalization coefficient.

13. The method according to any one of claims 1 to 11, wherein the method further comprises:
sending the compression parameter information, wherein the compression parameter information comprises the at least one of the following: the block size, the target compression ratio, the bit width, the downsampling ratio, the transform mode, the first parameter, the boundary of the value range of the first element, or the boundary of the value range of the normalization coefficient.

14. A data compression method, wherein the method comprises:

receiving a compressed bitstream, wherein the compressed bitstream comprises a frame header and a data bitstream; and

obtaining, based on a fourth mapping relationship, reconstructed data corresponding to the compressed bitstream, wherein the fourth mapping relationship corresponds to the bit width and the first parameter, the fourth mapping relationship comprises a plurality of bit values of a data bitstream and a plurality of first restored values that correspond to each other, and the first restored value is a result obtained by dequantizing the data bitstream.

15. The method according to claim 14, wherein the fourth mapping relationship further comprises a plurality of value ranges of a first element and the plurality of bit values of the data bitstream that correspond to each other, the first element is related to input data, and the compressed bitstream is determined based on the input data.

16. The method according to claim 15, wherein
the fourth mapping relationship is determined from a second mapping relationship based on the bit width and/or the first parameter, and the second mapping relationship comprises boundaries of all the value ranges of the first element in the fourth mapping relationship.

17. The method according to claim 14, wherein the frame header comprises information indicating a normalization coefficient; and
obtaining, based on the fourth mapping relationship, the reconstructed data corresponding to the compressed bitstream comprises:

obtaining, based on the fourth mapping relationship, a restored value corresponding to the data bitstream in the compressed bitstream; and
de-normalizing the restored value based on the normalization coefficient to obtain the reconstructed data.

18. The method according to claim 17, wherein the information indicating the normalization coefficient indicates a uniformly quantized value or a non-uniformly quantized value of the normalization coefficient.

19. The method according to any one of claims 14 to 18, wherein the frame header comprises information indicating the first parameter, and the information indicating the first parameter indicates a quantized value of the first parameter.

20. The method according to any one of claims 14 to 19, wherein the first parameter is determined based on an optimization indicator, and the optimization indicator comprises at least one of a normalized mean square error NMSE, a generalized cosine similarity GCS, a transmission throughput, and a bit error rate that correspond to the restored value obtained by dequantizing the data bitstream.

21. The method according to any one of claims 14 to 20, wherein the method further comprises:
determining compression parameter information based on a first transmission configuration, wherein the first transmission configuration is related to a signal bandwidth and/or a quantity of signal transmission streams, and the compression parameter information comprises at least one of the following: a block size, a target compression ratio, the bit width, a downsampling ratio, a transform mode, the first parameter, a boundary of a value range of the first element, or a boundary of a value range of the normalization coefficient.

22. The method according to any one of claims 14 to 20, wherein the method further comprises:
obtaining a third mapping relationship, wherein the third mapping relationship comprises a mapping relationship between a second transmission configuration and compression parameter information, the second transmission configuration is related to a modulation and coding scheme of a signal, and the compression parameter information comprises at least one of the following: a block size, a target compression ratio, the bit width, a downsampling ratio, a transform mode, the first parameter, a boundary of a value range of the first element, or a boundary of a value range of the normalization coefficient.

23. The method according to any one of claims 14 to 20, wherein the method further comprises:
receiving compression parameter information, wherein the compression parameter information comprises at least one of the following: a block size, a target compression ratio, the bit width, a downsampling ratio, a transform mode, the first parameter, a boundary of a value range of the first element, or a boundary of a value range of the normalization coefficient.

24. The method according to any one of claims 14 to 22, wherein the method further comprises:
sending the compression parameter information, wherein the compression parameter information comprises the at least one of the following: the block size, the target compression ratio, the bit width, the downsampling ratio, the transform mode, the first parameter, the boundary of the value range of the first element, or the boundary of the value range of the normalization coefficient.

25. A communication apparatus, wherein the apparatus comprises a module configured to perform the method according to any one of claims 1 to 24.

26. A communication apparatus, wherein the communication apparatus comprises a processor and a memory, the memory is configured to store computer instructions, and when the processor executes the instructions, the communication apparatus is enabled to perform the method according to any one of claims 1 to 24.

27. A computer-readable storage medium, wherein the computer-readable storage medium comprises a computer program or instructions, and when the computer program or the instructions are run on a computer, the method according to any one of claims 1 to 24 is performed.

28. A computer program product, wherein the computer program product comprises instructions, and when the instructions are run on a computer, the method according to any one of claims 1 to 24 is performed.

29. A chip, wherein the chip comprises a processor, and the processor is configured to run instructions, to enable an apparatus comprising the chip to perform the method according to any one of claims 1 to 24.

FIG. 1

RU

Data

DU

RU

Data

DU

FIG. 2

First unit

Second unit

S301

Obtain input data to be compressed

S302

Obtain a compressed bitstream based on a first mapping relationship, where the first mapping relationship includes a plurality of value ranges of a first element and a plurality of bit values of a data bitstream that correspond to each other

S303: Compressed bitstream

FIG. 3

| Value range of a first element | [0, 0.05] | (0.05, 0.1] | (0.1, 0.2] | (0.2, 0.35] | (0.35, 0.5] | (0.5, 0.7] | (0.7, 0.85] | (0.85, 1] |
|---|---|---|---|---|---|---|---|---|
| Bit value of a data bitstream | 000 | 001 | 010 | 011 | 100 | 101 | 110 | 111 |

First mapping relationship corresponding to a bit width 4

| Value range of a first element | [0, 0.1] | (0.1, 0.35] | (0.35, 0.7] | (0.7, 1] |
|---|---|---|---|---|
| Bit value of a data bitstream | 00 | 01 | 10 | 11 |

First mapping relationship corresponding to a bit width 3

First mapping relationship corresponding to the bit width 3

| 0.05 | 0.1 | 0.2 | 0.35 | 0.5 | 0.7 | 0.85 |
|---|---|---|---|---|---|---|

Second mapping relationship

First mapping relationship corresponding to the bit width 4

FIG. 4

FIG. 5

EP 4 738 735 A1



| Frame header | Sign bit $C$ | Absolute value information $B$ |
|---|---|---|

**FIG. 6**

Sign bits $C$      Absolute value information $B$

| Frame header | | ... | |

**FIG. 7**

| First unit | | Second unit |
|---|---|---|

S801: Compressed bitstream

S802

Obtain, based on a fourth mapping relationship, reconstructed data corresponding to the compressed bitstream, where the fourth mapping relationship includes a plurality of bit values of a data bitstream and a plurality of first restored values that correspond to each other

**FIG. 8**

| Maximum delay constraint or block size | Target compression ratio or bit width | Downsampling ratio | Transform mode | Transform parameter |
|---|---|---|---|---|

**FIG. 9**

First unit

Second unit

Compression parameter information

Compression parameter information

Compress input data based on the compression parameter information to obtain a compressed bitstream

Compressed bitstream

FIG. 10

Communication apparatus — 110

Processing module — 1101

Transceiver module — 1102

FIG. 11

— 120

Processor — 1201

CPU 0

CPU 1

Processor — 1208

CPU 0

CPU 1

Memory — 1203

1202

Communication interface — 1204

Output device — 1205

Input device — 1206

FIG. 12

# EP 4 738 735 A1

## INTERNATIONAL SEARCH REPORT

International application No.

**PCT/CN2023/115696**

### A. CLASSIFICATION OF SUBJECT MATTER

H04L1/00(2006.01)i; H04W28/06(2009.01)i

According to International Patent Classification (IPC) or to both national classification and IPC

### B. FIELDS SEARCHED

Minimum documentation searched (classification system followed by classification symbols)

IPC: H04L; H04W; H04N

Documentation searched other than minimum documentation to the extent that such documents are included in the fields searched

Electronic data base consulted during the international search (name of data base and, where practicable, search terms used)

CNTXT, ENTXTC, WPABS, WPABSC, 3GPP: 数据, 压缩, 输入, 映射, 码流, 比特, 参数, 取值, 位, 宽, 范围, 天线, 量化, 反量化, 恢复, data, compress, input, map, bit stream, parameter, value, width, range, antenna, quantiz+, quantif+, recover

### C. DOCUMENTS CONSIDERED TO BE RELEVANT

| Category* | Citation of document, with indication, where appropriate, of the relevant passages | Relevant to claim No. |
|---|---|---|
| A | CN 109936396 A (HUAWEI TECHNOLOGIES CO., LTD.) 25 June 2019 (2019-06-25) entire document | 1-29 |
| A | US 2020007150 A1 (IMAGINATION TECHNOLOGIES LTD.) 02 January 2020 (2020-01-02) entire document | 1-29 |
| A | CN 104754644 A (CHINA TELECOM CORP., LTD.) 01 July 2015 (2015-07-01) entire document | 1-29 |
| A | CN 116600119 A (TENCENT TECHNOLOGY (SHENZHEN) CO., LTD.) 15 August 2023 (2023-08-15) entire document | 1-29 |

☐ Further documents are listed in the continuation of Box C.      ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **29 May 2024** | **29 May 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

37

**INTERNATIONAL SEARCH REPORT**
Information on patent family members

International application No.

**PCT/CN2023/115696**

| Patent document cited in search report | | | Publication date (day/month/year) | Patent family member(s) | | | Publication date (day/month/year) |
|---|---|---|---|---|---|---|---|
| CN | 109936396 | A | 25 June 2019 | WO | 2019114690 | A1 | 20 June 2019 |
| US | 2020007150 | A1 | 02 January 2020 | None | | | |
| CN | 104754644 | A | 01 July 2015 | None | | | |
| CN | 116600119 | A | 15 August 2023 | None | | | |

Form PCT/ISA/210 (patent family annex) (July 2022)